(19) **Europäisches Patentamt European Patent Office Office européen des brevets**

(11) **EP 3 974 201 A1**

(12) **EUROPEAN PATENT APPLICATION**
published in accordance with Art. 153(4) EPC

(43) Date of publication:
**30.03.2022 Bulletin 2022/13**

(21) Application number: **20809906.9**

(22) Date of filing: **19.05.2020**

(51) International Patent Classification (IPC):
**B41M 1/30** $^{(2006.01)}$        **C09D 11/101** $^{(2014.01)}$

(52) Cooperative Patent Classification (CPC):
**B41M 1/30; C09D 11/101**

(86) International application number:
**PCT/JP2020/019778**

(87) International publication number:
**WO 2020/235557 (26.11.2020 Gazette 2020/48)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **22.05.2019 JP 2019095753**
**18.10.2019 JP 2019190822**
**20.12.2019 JP 2019230234**

(71) Applicant: **Toray Industries, Inc.**
**Tokyo, 103-8666 (JP)**

(72) Inventors:
• **KAWAI, Yurika**
**Shiga 520-8558 (JP)**
• **KOSHIMIZU, Noboru**
**Shiga 520-8558 (JP)**
• **INOUE, Takejiro**
**Shiga 520-8558 (JP)**

(74) Representative: **Kador & Partner PartG mbB**
**Corneliusstraße 15**
**80469 München (DE)**

(54) **PRINTING INK, METHOD FOR PRODUCING PRINTED WORK USING SAID INK, AND PRINTED WORK**

(57)     An object of the present invention is to provide an active energy ray-curable lithographic ink that exhibits good adhesion to a plastic film and does not cause a decrease in the adhesion capability even during hot-water treatment. The present invention encompasses a printing ink that includes (a) a urethane (meth)acrylate and (c) another polymerizable monomer, wherein the printing ink has an ink tack value of 5.0 or more and 18.0 or less and a viscosity (C) and a viscosity (B) that are both 5 Pa·s or more and 100 Pa·s or less, as measured at a rotational speed of 20 rpm and a rotational speed of 50 rpm respectively at 35°C, using a cone-plate rotating viscometer, and wherein the viscosity ratio (B)/(C) is 0.60 or more and 1.00 or less.

EP 3 974 201 A1

**Description**

TECHNICAL FIELD

The present invention relates to a printing ink, a method of producing a printed material using the same, and a printed material.

BACKGROUND ART

Lithography is a printing system widely used as a system capable of inexpensively supplying a large volume of printed material at high speed. In recent years, use of an active energy ray-curable lithographic ink that is instantaneously cured by irradiation with an active energy ray such as a mercury lamp, metal halide lamp, light-emitting diode, or electron beam has been expanding in many fields in view of installations, safety, environment, and high productivity.
In a conventional lithographic method, paper is often used as a substrate, but such a printing method is being extended to plastic films and the like from a viewpoint of diversification of usable substrates. In recent years in particular, a start has been made in the study of applications in which printing is performed onto flexible packages for which a thin plastic film is used as a substrate and which are used for daily goods, foodstuffs, pharmaceuticals, and the like.
An active energy ray-curable lithographic ink can be cured at room temperature in a short time, and thus, is considered to be an optimal material for forming an ink coating on a plastic film lacking in heat resistance. However, in some of the cases where an active energy ray-curable lithographic ink is used for printing on a substrate such as a thin plastic film, the adhesion between the ink and the surface of the plastic film is insufficient. Because of this, progress is being made in the development of an active energy ray-curable lithographic ink having excellent adhesion to a plastic film (see Patent Literature 1).
In addition, a thin plastic film to be used for flexible packages is flexible and easily bent, thus making it desired that the ink coating is flexible as well as being firmly adhered to the surface of the thin film. In one aspect disclosed, a polymerizable urethane acrylate having excellent flexibility is used to enhance the flexibility of an active energy ray-curable lithographic ink (see Patent Literature 2).

Citation List

Patent Literature

Patent Literature 1: JPH03-252472A
Patent Literature 2: WO2015/141552

SUMMARY OF INVENTION

Technical Problem

An active energy ray-curable lithographic ink disclosed in Patent Literature 1 provides enhanced adhesion, but in some of the cases where the ink is printed onto a plastic film, the adhesion between the ink and the plastic film is insufficient, depending on the composition and surface condition of the plastic film.
An active energy ray-curable lithographic ink disclosed in Patent Literatures 2 provides enhanced flexibility, but the adhesion of the ink to a plastic film tends to decrease markedly during heat-treatment such as boiling or retorting that is essential in applications such as food packaging.
In addition, adding ink to a urethane compound causes a problem of degradation of the printing quality (such as anti-scumming or leveling property).
In view of this, an object of the present invention is to overcome such problems with conventional technologies, and to provide: a printing ink suitable for active energy ray-curable lithography in particular; and a method of producing a printed material using the ink, wherein the ink exhibits good adhesion to a plastic film, does not decrease in the adhesion capability during hot-water treatment, and makes it possible to obtain a printed material having good printing quality.

Solution to Problem

The inventors have reached the present invention through the realization that is as follows: adding a urethane compound to ink is not accompanied by allowing the urethane compound and the ink to be dissolved into each other, but accompanied by impairing the Newtonian property of the ink, and in addition, causes the urethane bond to enhance the cohesive force, and thus, the viscosity and tack value of the ink rise, degrading the printing quality (such as anti-scumming or leveling property).

That is, the present invention encompasses a printing ink characterized by including (a) a urethane (meth)acrylate and (c) another polymerizable monomer, wherein the printing ink has an ink tack value of 5.0 or more and 18.0 or less and a viscosity (C) and a viscosity (B) that are both 5 Pa·s or more and 100 Pa·s or less, as measured at a rotational speed of 20 rpm and a rotational speed of 50 rpm respectively at 35°C, using a cone-plate rotating viscometer, and wherein the viscosity ratio (B)/(C) is 0.60 or more and 1.00 or less.

In addition, it is preferable that the printing ink according to the present invention further includes a resin.

In addition, the present invention encompasses a printing ink characterized by including: (a) a urethane (meth)acrylate, (b) a resin having an ethylenically unsaturated group and a hydrophilic group; and (c) another polymerizable monomer.

In addition, the present invention encompasses a method of producing a printed material by lithography using a printing ink according to the present invention, the method characterized by including a step of transferring an ink to a substrate to be printed, followed by irradiating the resulting material with an active energy ray.

In addition, the present invention encompasses a method of producing a printed material by lithography using a printing ink according to the present invention, the method characterized in that a waterless lithography plate is used as a lithography plate.

In addition, the present invention encompasses a method of producing a printed material, characterized by including the steps of: printing a substrate by lithography using a printing ink according to the present invention, followed by irradiating the resulting material with an active energy ray; laminating at least a sealant film onto the printed substrate; and performing a hot-water treatment.

In addition, the present invention encompasses a printed material characterized by including at least a substrate, a printing ink according to the present invention, an adhesive, and a sealant film.

Advantageous Effects of Invention

A printing ink according to the present invention and a method of producing a printed material using the same make it possible to obtain a printed material that exhibits good adhesion to a plastic film, does not decrease in the adhesion capability during hot-water treatment, and has good printing quality.

DESCRIPTION OF EMBODIMENTS

Below, the present invention will be specifically described. In the description of the scope of the present invention, the term "obtained" is used with a raw material mentioned, but is not limited to anything obtained by reaction of the raw material mentioned, and encompasses a thing having the same structure as the raw material mentioned or as a thing obtainable through the reaction.

A printing ink according to the present invention contains (a) a urethane (meth)acrylate. In this regard, a "(meth)acrylate" is a generic term that encompasses an acrylate and a methacrylate.

Hydrogen bonding between urethane bonds contained in (a) the urethane (meth)acrylate forms a hard segment, making it possible to impart tenacity to an ink coating, and in addition, enabling the ink coating to be firmly bonded to the surface of a plastic film or the like to thereby have good adhesion. In addition, an acrylic group contained in (a) the urethane (meth)acrylate induces a curing reaction through irradiation with an active energy ray, thus making it possible to impart heat resistance to the ink coating. Furthermore, (a) the urethane (meth)acrylate contains a polyol to thereby form a soft segment, thus making it possible to impart flexibility to the ink coating.

Such (a) a urethane (meth)acrylate can be synthesized by reaction of a (meth)acrylic acid having a hydroxyl group, a polyisocyanate compound, and a polyol compound.

(a) the urethane (meth)acrylate preferably has at least an ether structure in the polyol. A polyether polyol has water resistance, a low solubility parameter (SP value), and good compatibility with a resin constituting an ink, is inexpensive, and thus, is particularly preferable. Examples of a polyhydric alcohol as a raw material of a polyether polyol include, but are not limited particularly to: low-molecular-weight alcohol compounds such as ethylene glycol, 1,2-propanediol, 1,3-propanediol, 1,2-butanediol, 1,3-butanediol, 1,4-butanediol, 1,5-pentanediol, 1,6-hexanediol, 3-methyl-1,5-pentanediol, neopentyl glycol, 1,8-octanediol, 1,9-nonanediol, diethylene glycol, dipropylene glycol, 1,4-cyclohexanedimethanol, ethylene oxide or propylene oxide adducts of bisphenol A, trimethylolpropane, glycerin, and pentaerythritol; low-molecular-weight aminoalcohol compounds such as monoethanolamine and diethanolamine; and the like. Among these, polytetramethylene ether glycol (PTMG) having the structure of 1,4-butanediol has a high cohesive force to thereby enhance the ink coating properties, and thus, is particularly preferable. On the other hand, polypropylene glycol has a branch and accordingly holds a low cohesive force, thereby making it possible to retain the fluidity of the ink suitably and to inhibit the tack from increasing, and thus, is particularly preferable.

In addition, (a) the urethane (meth)acrylate preferably has any one or more of an ester structure and a polycarbonate structure. The urethane (meth)acrylate having any one or more of an ester structure and a polycarbonate structure enables such a rigid structure to effectively enhance the heat resistance and coating properties of an ink. In addition, the rigid structure inhibits entanglement of the molecular chains formed, makes the viscosity of the ink low, enhances the fluidity of the ink, and thus, makes it possible to achieve good transfer during printing.

Examples of preferable alcohols that give an ester structure include a polyhydric alcohol. In addition, examples of dicarboxylic acids that give an ester structure include, but are not limited particularly to: phthalic acids, isophthalic acids, terephthalic acids, adipic acids, oxalic acids, maleic acids, fumaric acids, sebacic acids, and the like. Among these, isophthalic acids and adipic acids are relatively inexpensive, have good heat resistance, retain good compatibility with ink, and thus, are particularly preferable.

In addition, examples of carbonate polyols that give a urethane having a carbonate structure include pentamethylene carbonate diol, hexamethylene carbonate diol, hexane carbonate diol, decane carbonate diol, and the like. However, the high cohesive force of carbonate bonds leads to thickening and degradation of compatibility with ink as the amount of carbonate bonds increases. Accordingly, pentamethylene carbonate diol or hexamethylene carbonate diol, which has a branched chain that inhibits the hydrogen bonding strength of carbonate bonds, is particularly preferable.

Without particular limitation, a polyisocyanate compound to be used as a raw material for (a) the urethane (meth)acrylate is preferably a diisocyanate for the purposes of inhibiting the viscosity of a urethane compound obtained by reaction between a hydroxyl group of a polyol and an isocyanate group of a polyisocyanate compound, and maintaining compatibility with the resin and monomer in the ink. Such a diisocyanate is not limited to any particular one. Examples of compounds having an aromatic ring structure include toluene diisocyanate, diphenylmethane diisocyanate, and xylylene diisocyanate. Examples of compounds having an alicyclic structure include isophorone diisocyanate, 4,4-methylenebiscyclohexyl diisocyanate (what is called hydrogenated MDI), and hydrogenated xylylene diisocyanate. Examples of compounds having an aliphatic structure include hexamethylene diisocyanate and the like. These diisocyanates can be used singly or in combination of two or more kinds thereof.

In addition, an isocyanate included in (a) the urethane (meth)acrylate preferably has an aromatic ring structure or an alicyclic structure in order to have excellent coating properties, more preferably has an alicyclic structure in order to have resistance to yellowing due to heat.

A raw material for giving an acrylic acid ester of (a) the urethane (meth)acrylate contained in an ink according to the present invention is preferably an acrylic acid ester having a hydroxyl group. Without particular limitation, a hydroxyl-group-containing acrylic acid ester is preferably a hydroxyl-group-containing acrylic acid ester having two or more acrylic groups from a viewpoint of making it possible to enhance the heat resistance and water resistance. Examples of hydroxyl-group-containing acrylic acid esters having two or more acrylic groups include, but are not limited particularly to: a poly(meth)acrylate of a polyhydric alcohol such as trimethylolpropane, glycerin, pentaerythritol, diglycerine, ditrimethylolpropane, isocyanuric acid, and dipentaerythritol; alkylene oxide adducts thereof; and the like. More specific examples include di(meth)acrylate of trimethylolpropane, di(meth)acrylate of glycerin, di or tri(meth)acrylate of pentaerythritol, di or tri(meth)acrylate of diglycerine, di or tri(meth)acrylate of ditrimethylolpropane, di-, tri-, tetra-, or penta(meth)acrylate of dipentaerythritol, and ethylene oxide adducts, propylene oxide adducts, and tetraethylene oxide adducts thereof. Among these, pentaerythritol triacrylate can be used particularly preferably. These hydroxyl-group-containing acrylic acid esters having two or more acrylic groups can be used singly or in combination of two or more kinds thereof.

Without particular limitation, the polyisocyanate compound is preferably a diisocyanate for the purposes of inhibiting the viscosity of a urethane compound obtained by reaction between the following: a hydroxyl group in the below-mentioned resin such as (b) a resin having an ethylenically unsaturated group and a hydrophilic group or in the below-mentioned (c) another polymerizable monomer; and an isocyanate group of a polyisocyanate compound, and maintaining compatibility with the resin and the monomer in the ink. Examples of diisocyanates as compounds having an aromatic ring structure include toluene diisocyanate, diphenylmethane diisocyanate, and xylylene diisocyanate. Examples of compounds having an alicyclic structure include isophorone diisocyanate (IPDI), 4,4-methylenebiscyclohexyl diisocyanate (what is called hydrogenated MDI), and hydrogenated xylylene diisocyanate. Examples of compounds having an aliphatic structure include hexamethylene diisocyanate and the like. These diisocyanates can be used singly or in combination of two or more kinds thereof. Such a diisocyanate preferably has an aromatic ring structure or an alicyclic structure in order to have excellent coating properties, and is preferably a diisocyanate having an alicyclic structure in order to have excellent yellowing resistance and weather resistance. Among these, an IPDI has a bulky structure, accordingly allows the urethane compound to have a low cohesive force, and accordingly, can inhibit the viscosity. Through the inhibition of the cohesive force, an IPDI also has excellent compatibility with the resin and the monomer in the ink, exhibits high adhesion, and thus, is particularly preferable. In addition, the aromatic ring structure is preferable from viewpoints of excellent reactivity and availability of inexpensive raw materials.

In addition, (a) the urethane (meth)acrylate contained in an ink according to the present invention preferably includes the following aspects:

(1) a compound having: a urethane structure obtained from a polyisocyanate having at least an aromatic ring structure or an alicyclic structure; and an ester structure obtained from a carboxylic acid;

(2) a compound having: a urethane bond structure obtained from a diisocyanate having at least an alicyclic structure; and an ester structure obtained from an adipic acid or an isophthalic acid;

(3) a compound having: a urethane structure obtained from a polyisocyanate having at least an aromatic ring structure or an alicyclic structure; and a carbonate structure composed of carbonate dipolyol;

(4) a compound having: a urethane structure obtained from a diisocyanate having at least an alicyclic structure; and a carbonate structure selected from at least one selected from polypentamethylene carbonate diol and polyhexamethylene carbonate diol;

(5) a compound having a urethane structure and an acrylic group, wherein the compound is obtained by allowing a hydroxyl-group-containing acrylic acid ester to react with an isocyanate compound; and

(6) a compound having: a urethane structure obtained by allowing a pentaerythritol triacrylate to react with a diisocyanate compound having an aromatic ring structure; and an acrylic group.

The weight-average molecular weight of the above-mentioned (a) urethane (meth)acrylate is preferably 100 or more because such a weight-average molecular weight enhances the hot-water resistance of an active energy ray-curable lithographic ink. In addition, the weight-average molecular weight is more preferably 300 or more, still more preferably 500 or more, still more preferably 800 or more, still more preferably 1,000 or more, still more preferably 1,500 or more, from a viewpoint of allowing the ratio of the soft segment composed of a polyol component to be equal to or greater than a given value in one molecule, and thus making it possible to impart flexibility to the coating to enhance the adhesive force. In addition, the weight-average molecular weight is preferably 10,000 or less, more preferably 7,000 or less, still more preferably 5,000 or less, from the viewpoint that retaining compatibility with the ink leads to retaining the fluidity of the ink, making it possible to achieve a good coating appearance (leveling property) and anti-scumming during printing, and in addition, making it possible to effect a Newtonian behavior as below-mentioned. The weight-average molecular weight of the resin can be calculated by measurement using gel permeation chromatography (GPC) and conducting the calculation in terms of polystyrene.

The urethane bond fraction of (a) the urethane (meth)acrylate is preferably 5 mass% or more, still more preferably 10 mass% or more, still more preferably 15 mass% or more, because such a urethane bond fraction inhibits molecular chain entanglement due to the rigid urethane bond to thereby inhibit a rise in the viscosity of the ink, and in addition, affords the effects of enhancing the cohesive force of the ink coating and enhancing an adhesive strength obtained by forming a hydrogen bond with the surface of the substrate. On the other hand, the urethane bond fraction is preferably 40 mass% or less, more preferably 30 mass% or less, still more preferably 20 mass% or less, because such a urethane bond fraction affords good compatibility with the ink containing: the below-mentioned resin such as (b) a resin having an ethylenically unsaturated group and a hydrophilic group; and (c) another polymerizable monomer, to thereby retain the fluidity of the ink suitably. In this regard, the bond fraction can be calculated from the following: a ratio between the C-H peak area of an internal standard material and the N-H peak area derived from a urethane bond, as measured by proton magnetic resonance (1H-NMR); a ratio of the number of protons between the internal standard material and the urethane bond; and the molecular weight of the urethane bond and the molecular weight of the internal standard material.

The amount of (a) the urethane (meth)acrylate with respect to the total amount of the ink is preferably 1 mass% or more, more preferably 3 mass% or more, more preferably 5 mass% or more, still more preferably 7 mass% or more, because such an amount affords good adhesion. In addition, regulating the amount to 30 mass% or less, more preferably 20 mass% or less, still more preferably 15 mass% or less, makes it possible to retain good compatibility with the resin. Such an amount makes it possible to inhibit a rise in the tack of the ink and obtain a printed material the picture on which has good positional accuracy. In addition, such an amount makes it possible to retain the fluidity of the ink suitably, thus making it possible to obtain a printed material having an excellent coating appearance (leveling property), and in addition, having no scumming (transfer of ink onto a non-printing part), and thus, is preferable.

In a printing ink according to the present invention, the ratio of (a) the urethane (meth)acrylate is preferably 40 mass% or less, more preferably 35 mass% or less, with respect to the below-mentioned (c) another polymerizable monomer, from a viewpoint of retaining good compatibility with the ink. The retention of good compatibility makes it possible to obtain the effects of inhibiting a rise in the tack of the ink and obtaining a good coating appearance and anti-scumming, as above-mentioned. In addition, the ratio is preferably 3 mass% or more, more preferably 7 mass% or more, because such a ratio leads to expressing good adhesion between the substrate and the ink. In addition, the amount of the urethane (meth)acrylate within the above-mentioned range makes it possible to well retain the fluidity of the ink and the hot-water resistance of the cured coating of the ink.

It is preferable that a printing ink according to the present invention further includes a resin. The ink including a resin makes it possible to obtain fluidity suitable for printing, for example, to prevent the scattering (misting) of the ink during printing.

Examples of a resin to be included in a printing ink according to the present invention include, but are not limited particularly to: acrylic resins, styrene acrylic resins, styrene maleic acid resins, rosin-modified maleic acid resins, rosin-modified acrylic resins, epoxy resins, polyester resins, polyurethane resins, and phenol resins. Among the main-chain structures derived from the above-mentioned resins, the structures to be preferably used are those derived from acrylic resins, styrene acrylic resins, and styrene maleic acid resins from viewpoints of the availability of the monomer as a raw material of the resin, low cost, easy synthesis, compatibility with other components of the ink, dispersibility of the pigment, and the like.

In addition, a particularly preferable resin to be included in a printing ink according to the present invention is (b) a resin having an ethylenically unsaturated group and a hydrophilic group. The ethylenically unsaturated group of the resin reacts with the acrylic group contained in (a) the urethane (meth)acrylate during irradiation with an active energy ray, and thereby forms a firm covalent bond, thus enhancing the resistance of the ink coating to a hot-water treatment and the like. In addition, the hydrophilic group interacts firmly with the urethane bond contained in (a) the urethane (meth)acrylate, and thus, markedly enhances the resistance of the ink coating to a hot-water treatment or the like. This is based on the presumption that the hydrophilic groups in the ink interact with one another, enhancing the cohesive force of the ink. Furthermore, the increased cohesive force of the ink enhances the repellency of the ink to a non-printing part, so that the anti-scumming (anti-scumming) is enhanced. In addition, the ethylenically unsaturated group reacts with a radical species to thereby form a cross-linked structure, thus enhancing the sensitivity of a printing ink according to the present invention to an active energy ray.

Preferable examples of the hydrophilic group of (b) the resin having an ethylenically unsaturated group and a hydrophilic group include a hydroxyl group, amino group, mercapto group, carboxyl group, sulfo group, and phosphate group. Among these, a carboxyl group and a hydroxyl group, which interact well with a urethane bond of the (a) compound, are more preferable. It is particularly preferable to contain both a carboxyl group and a hydroxyl group.

The acid value of (b) the resin having an ethylenically unsaturated group and a hydrophilic group is preferably 30 mgKOH/g or more, more preferably 60 mgKOH/g or more, still more preferably 75 mgKOH/g or more, from viewpoints of improving the pigment dispersibility of the ink, and enhancing the anti-scumming. In addition, the acid value is preferably 250 mgKOH/g or less, more preferably 200 mgKOH/g or less, still more preferably 150 mgKOH/g or less, which lead to providing solubility in a polyfunctional (meth)acrylate, and inhibiting the polar groups from raising the viscosity, to thereby retain the fluidity of the ink. In this regard, the acid value of the resin can be determined in accordance with "3.1 neutralization titration" in the test method of JIS K 0070: 1992.

The iodine value of (b) the resin having an ethylenically unsaturated group and a hydrophilic group is preferably 0.5 mol/kg or more, more preferably 1.0 mol/kg or more, still more preferably 1.5 mol/kg or more, which result in achieving good curing sensitivity to an active energy ray. In addition, the iodine value is preferably 3.0 mol/kg or less, more preferably 2.5 mol/kg or less, still more preferably 2.0 mol/kg or less, which result in enhancing the storage stability of the ink. The iodine value of the resin having an ethylenically unsaturated group and a hydrophilic group can be regulated by the amount of the ethylenically unsaturated groups. In this regard, the iodine value of the resin can be determined in accordance with the method described in Section 6.0 in the test method of JIS K 0070: 1992.

Specific examples of the skeleton of (b) the resin having an ethylenically unsaturated group and a hydrophilic group include (meth)acrylic acid copolymers, (meth)acrylic acid-(meth)acrylic acid ester copolymers, styrene-(meth)acrylic acid copolymers, styrene-(meth)acrylic acid-(meth)acrylic acid ester copolymers, styrene-maleic acid copolymers, styrene-maleic acid-(meth)acrylic acid copolymers, styrene-maleic acid-(meth)acrylic acid ester copolymers, and the like.

Among the above-mentioned resins, the resin having an ethylenically unsaturated group and a hydrophilic group and having a main-chain structure derived from a resin selected from acrylic resins, styrene acrylic resins, and styrene maleic acid resins can be produced by the following method.

The resin having a hydrophilic group is obtained by polymerizing or copolymerizing a compound(s) using a polymerization initiator, wherein the compound(s) is/are selected from the following: carboxyl-group-containing monomers such as (meth)acrylic acids, itaconic acids, crotonic acids, maleic acids, fumaric acids, vinyl acetate, and acid anhydrides thereof; hydroxyl-group-containing monomers such as 2-hydroxyethyl (meth)acrylate; amino-group-containing monomers such as dimethylaminoethyl (meth)acrylate; mercapto-group-containing monomers such as 2-(mercaptoacetoxy)ethyl (meth)acrylate; sulfo-group-containing monomers such as (meth)acrylamide t-butyl sulfonic acid; phosphate-group-containing monomers such as 2-(meth)acryloyloxy ethyl acid phosphate; (meth)acrylic acid esters; styrene; (meth)acrylonitrile; vinyl acetate; and the like. A resin having an ethylenically unsaturated group and a hydrophilic group is obtained by allowing an ethylenically unsaturated compound having a glycidyl group or an isocyanate group, an acrylic acid chloride, a methacrylic acid chloride, or an allyl chloride to undergo addition reaction with a mercapto group, amino group, hydroxyl group, or carboxyl group that is an active hydrogen-containing group in the resin having a hydrophilic group. The method to be used, however, is not limited to the above-mentioned method.

In addition, specific examples of the ethylenically unsaturated compound having a glycidyl group include glycidyl (meth)acrylate, allyl glycidyl ether, glycidyl crotonate, glycidyl isocrotonate, and the like.

In addition, specific examples of the ethylenically unsaturated compound having an isocyanate group include (meth)acryloyl isocyanate, (meth)acryloylethyl isocyanate, and the like.

The weight-average molecular weight of (b) the resin having an ethylenically unsaturated group and a hydrophilic group is preferably 100,000 or less, more preferably 75,000 or less, still more preferably 50,000 or less, because such a weight-average molecular weight makes it possible to retain the fluidity of the ink. In addition, the weight-average molecular weight is preferably 5,000 or more, more preferably 15,000 or more, still more preferably 20,000 or more, because such a weight-average molecular weight enhances the hot-water treatment resistance and anti-scumming of a printed material based on an active energy ray-curable lithographic ink. The weight-average molecular weight of the resin can be determined by measurement in terms of polystyrene using gel permeation chromatography (GPC).

The amount of a resin such as (b) the resin having an ethylenically unsaturated group and a hydrophilic group in a printing ink according to the present invention is preferably 5 mass% or more and 50 mass% or less. The resin in an amount within the above-mentioned range makes it possible to well retain the resistance of the ink coating to hot-water treatment.

A printing ink according to the present invention contains (c) another polymerizable monomer. Here, compounds belonging to the (a) compound and compounds belonging to resin compounds such as the (b) compound are not classified into (c) the another polymerizable monomer. Containing (c) the another polymerizable monomer makes it possible to adjust the ink properties desired for lithography, such as viscosity and a leveling property. In addition, irradiation with an active energy ray induces an addition reaction that allows (c) the another polymerizable monomer to cause cross-linking between (a) the urethane (meth)acrylate and (b) the resin having an ethylenically unsaturated group and a hydrophilic group, thus making it possible to further enhance the resistance of the ink coating to hot-water treatment and the like.

From a viewpoint of compatibility with a resin such as (b) the resin having an ethylenically unsaturated group and a hydrophilic group, (c) the another polymerizable monomer preferably contains a hydrophilic polyfunctional (meth)acrylate, particularly preferably contains at least a hydroxyl-group-containing polyfunctional (meth)acrylate. In the ink, the hydroxyl group interacts with the urethane bond of (a) the urethane (meth)acrylate and the hydrophilic group of a resin such as (b) the resin having an ethylenically unsaturated group and a hydrophilic group, thus making it possible to obtain good resistance to hot-water treatment and the like. In addition, such interaction makes it possible to provide good dispersibility to a pigment in the ink, leading to enhancing the fluidity of the ink. Enhancing the fluidity of the ink leads to exhibiting good transfer during printing.

The hydroxyl value of the hydroxyl-group-containing polyfunctional (meth)acrylate is preferably 50 mgKOH/g or more, more preferably 75 mgKOH/g or more, still more preferably 100 mgKOH/g or more, from a viewpoint of enhancing the pigment dispersibility. In addition, the hydroxyl value is preferably 200 mgKOH/g or less, more preferably 180 mg-KOH/g or less, still more preferably 160 mgKOH/g or less, because such a value makes it possible to inhibit the polar groups from raising the viscosity and retain the fluidity of the ink well.

Examples of raw materials of the polyfunctional (meth)acrylate having a hydroxyl group include polyhydric alcohols such as trimethylolpropane, glycerin, pentaerythritol, diglycerine, ditrimethylolpropane, isocyanuric acid, and dipentaerythritol. Esterifying any of these and (meth)acrylate results in obtaining a polyfunctional (meth)acrylate having a hydroxyl group. An alkylene oxide may be added.

Examples of polyfunctional (meth)acrylates having a hydroxyl group include di(meth)acrylate of trimethylolpropane, di(meth)acrylate of glycerin, di or tri(meth)acrylate of pentaerythritol, di or tri(meth)acrylate of diglycerine, di or tri(meth)acrylate of ditrimethylolpropane, di-, tri-, tetra-, or penta(meth)acrylate of dipentaerythritol, and ethylene oxide adducts, propylene oxide adducts, and tetraethylene oxide adducts thereof.

Among these, pentaerythritol tri(meth)acrylate, diglycerine tri(meth)acrylate, and ditrimethylolpropane tri(meth)acrylate are particularly preferable because these allow an ink according to the present invention to have excellent pigment dispersibility and fluidity.

An ink according to the present invention containing (c) the another polymerizable monomer in an amount of preferably 10 mass% or more, more preferably 15 mass% or more, still more preferably 20 mass% or more, makes it possible to effectively enhance the resistance of the ink coating to hot-water treatment. In addition, containing the monomer in an amount of preferably 70 mass% or less, more preferably 60 mass% or less, still more preferably 50 mass% or less, makes it possible to inhibit the polar groups from raising the viscosity, and retain the fluidity well, and makes it possible to inhibit a rise in the tack of the ink and obtain a good coating appearance (leveling property) and anti-scumming.

(c) the another polymerizable monomer contained in an ink according to the present invention preferably contains a (meth)acrylate having an alicyclic skeleton or a $C_{6-18}$ aliphatic skeleton. Adding the (meth)acrylate having an alicyclic skeleton or a $C_{6-18}$ aliphatic skeleton results in decreasing the viscosity and surface free energy of the ink, thus enhancing the ink transfer and adhesion to a substrate to be printed.

Among the (meth)acrylates having an alicyclic skeleton or a $C_{6-18}$ aliphatic skeleton, (meth)acrylates having a $C_{6-18}$ aliphatic skeleton are preferable to enhance the ink transfer onto the substrate.

Additionally, among the (meth)acrylates having an alicyclic skeleton or a $C_{6-18}$ aliphatic skeleton, (meth)acr-

ylates having an alicyclic skeleton exhibit small volume shrinkage during curing by irradiation with an active energy ray, enhance the adhesion to the substrate, and thus, are preferable. The alicyclic skeleton is more preferably a ring-fused skeleton, because a ring-fused skeleton is more rigid, exhibits small volume shrinkage during curing, and yields a cured coating the film properties of which, such as scratch resistance, are good. Examples of the alicyclic skeleton include a norbornane skeleton, adamantane skeleton, tricyclodecane skeleton, dicyclopentadiene skeleton, and the like. A tricyclodecane skeleton is particularly preferable.

In cases where the (meth)acrylate having an alicyclic skeleton or a $C_{6-18}$ aliphatic skeleton is added, the addition amount is preferably 1 mass% or more, more preferably 5 mass% or more, still more preferably 10 mass% or more, in an ink according to the present invention because such an addition amount enhances the ink transfer and adhesion to the substrate. In addition, the amount is preferably 40 mass% or less, more preferably 35 mass% or less, because such an amount leads to inhibiting a decrease in the viscosity of the ink and retaining the anti-scumming.

The (meth)acrylate having an alicyclic skeleton or a $C_{6-18}$ aliphatic skeleton leads to achieving good curing sensitivity to an active energy ray, and enhances the strength of the cured film to enhance the adhesion, and thus, it is preferable to have two or more (meth)acrylate-derived structures.

The (meth)acrylate having a $C_{6-18}$ aliphatic skeleton preferably has 6 or more carbon atoms, more preferably 8 or more carbon atoms, still more preferably 10 or more carbon atoms, because such a number enhances the ink transfer to the substrate. The number of carbon atoms is preferably 18 or less, more preferably 16 or less, still more preferably 14 or less, because such a number inhibits a decrease in compatibility with (b) the resin having an ethylenically unsaturated group and a hydrophilic group, and with the hydrophilic polyfunctional (meth)acrylate, and inhibits a rise in the viscosity of the ink, and inhibits a decrease in ink transfer.

The ratio of the (meth)acrylate having a $C_{6-18}$ aliphatic skeleton with respect to the total amount (1.00 part by mass) of the hydrophilic polyfunctional (meth)acrylate is preferably 0.02 part by mass or more, more preferably 0.04 part by mass or more, still more preferably 0.06 part by mass or more, because such a ratio leads to suitably retaining compatibility with the hydrophilic polyfunctional (meth)acrylate and enhancing the ink transfer. For the same reason, the ratio of the (meth)acrylate having a $C_{6-18}$ aliphatic skeleton with respect to the total amount (1.00 part by mass) of the hydrophilic polyfunctional (meth)acrylate is preferably 0.30 part by mass or less, more preferably 0.20 part by mass or less, still more preferably 0.15 part by mass or less, still more preferably 0.12 part by mass or less.

The ratio of the (meth)acrylate having a $C_{6-18}$ aliphatic skeleton with respect to the total amount (1.00 part by mass) of (b) the resin having an ethylenically unsaturated group and a hydrophilic group is preferably 0.10 part by mass or more, more preferably 0.15 part by mass or more, still more preferably 0.20 part by mass or more, because such a ratio leads to suitably retaining compatibility with (b) the resin having an ethylenically unsaturated group and a hydrophilic group, and enhancing the ink transfer. For the same reason, the ratio of the (meth)acrylate having a $C_{6-18}$ aliphatic skeleton with respect to the total amount (1.00 part by mass) of (b) the resin having an ethylenically unsaturated group and a hydrophilic group is preferably 0.60 part by mass or less, more preferably 0.45 part by mass or less, still more preferably 0.30 part by mass or less.

Specific examples of the (meth)acrylate having an alicyclic skeleton or a $C_{6-18}$ aliphatic skeleton include: monofunctional (meth)acrylates having a $C_{6-18}$ aliphatic skeleton, such as hexyl (meth)acrylate, octyl (meth)acrylate, nonyl (meth)acrylate, dodecyl (meth)acrylate, stearyl (meth)acrylate, and isostearyl (meth)acrylate; (meth)acrylates having an alicyclic skeleton, such as isobornyl (meth)acrylate, norbornyl (meth)acrylate, norbornane-2-methanol (meth)acrylate, cyclohexyl (meth)acrylate, tricyclopentenyl (meth)acrylate, tricyclopentenyloxy (meth)acrylate, and tricyclodecane monomethylol (meth)acrylate; and the like.

Examples of difunctional (meth)acrylates having a $C_{6-18}$ aliphatic skeleton include 1,6-hexanediol di(meth)acrylate, 1,9-nonanediol di(meth)acrylate, 1,7-heptanediol di(meth)acrylate, 1,8-octanediol di(meth)acrylate, 1,10-decanediol di(meth)acrylate, 1,11-undecanediol di(meth)acrylate, 1,12-dodecanediol di(meth)acrylate, 1,13-tridecanediol di(meth)acrylate, 1,14-tetradecanediol di(meth)acrylate, 1,15-pentadecanediol di(meth)acrylate, 1,16-hexadecanediol di(meth)acrylate, 1,17-heptadecanediol di(meth)acrylate, 1,18-octadecanediol di(meth)acrylate, 4-methyl-1,10-decanediol di(meth)acrylate, 4-ethyl-1,10-decanediol di(meth)acrylate, and the like. Examples of (meth)acrylates having an alicyclic skeleton include dicyclopentadiene dimethanol di(meth)acrylate, tricyclodecane dimethanol di(meth)acrylate, and the like. Other examples include polyester di(meth)acrylates having a $C_{6-18}$ aliphatic skeleton as a repeating unit. It is possible to contain two or more of these. Among these, tricyclodecane dimethanol di(meth)acrylate, which undergoes small volume shrinkage during curing, has a ring-fused skeleton, and is difunctional, is particularly preferable. In addition, 1,10-decanediol di(meth)acrylate is particularly preferable in order to suitably retain compatibility with (b) the resin having an ethylenically unsaturated group and a hydrophilic group and with a hydrophilic polyfunctional (meth)acrylate, and to enhance the ink transfer. Here, the functional number refers to the number of (meth)acrylate-derived structures.

An ink according to the present invention preferably contains a pigment composed of an organic pigment and/or an inorganic pigment. Specific examples of organic pigments include phthalocyanine pigments, soluble azo pigments, insoluble azo pigments, lake pigments, quinacridone pigments, isoindoline pigments, indanthrene pigment, and metal complex pigments. More specific examples include phthalocyanine blue, phthalocyanine green, azo red, monoazo red, monoazo yellow, disazo red, disazo yellow, quinacridone red, quinacridone magenta, isoindoline yellow, and the like.

Examples of inorganic pigments include titanium oxide, zinc oxide, alumina white, calcium carbonate, barium sulfate, iron red, cadmium red, chrome yellow, zinc yellow, Prussian blue, ultramarine, oxide-coated glass powder, oxide-coated mica, oxide-coated metal particles, aluminium powder, gold powder, silver powder, copper powder, zinc powder, stainless steel powder, nickel powder, organic bentonite, iron oxide, carbon black, graphite, and the like.

For use for an ink to be used to print a prime coat color onto a transparent plastic film, preferable examples include white pigments which provide masking properties, such as titanium dioxide, zinc oxide, and alumina white.

The particle diameter of the white pigment is preferably 200 nm or more and 300 nm or less, in which case the transmittance of visible light is most decreased by scattering.

In cases where an organic pigment having a specific gravity of 2 or less or carbon black is used, the concentration of the pigment in a printing ink according to the present invention is preferably 5 mass% or more, more preferably 10 mass% or more, still more preferably 15 mass% or more, because such a concentration affords a printing density. In addition, the concentration is preferably 50 mass% or less, more preferably 45 mass% or less, still more preferably 40 mass% or less, because such a concentration enhances the ink fluidity to thereby afford good transfer. In cases where an inorganic pigment having a specific gravity of more than 2 is used, the concentration is preferably 20 mass% or more, more preferably 30 mass% or more, still more preferably 40 mass% or more, because such a concentration affords a printing density. In addition, the concentration is preferably 70 mass% or less, more preferably 60 mass% or less, still more preferably 50 mass% or less, because such a concentration enhances the ink fluidity to thereby afford good transfer.

A printing ink according to the present invention preferably contains an acylphosphine oxide compound. The acylphosphine oxide compound absorbs light in a long-wavelength region of 350 nm or more, and thus, has high sensitivity also in a system containing a pigment that absorbs or reflects ultraviolet light. In addition, such an acylphosphine oxide compound has a photobleaching effect, by which the compound no longer absorbs light once the compound has undergone reaction, and this effect provides excellent internal curability. In addition, the acylphosphine oxide compound generally has a low solubility in a polyfunctional (meth)acrylate, and thus, does not diffuse in ink uniformly. As a result, in some cases, the acylphosphine oxide compound does not exhibit enhanced sensitivity commensurate with the addition amount, and/or precipitates to thereby decrease the fluidity of the ink. On the other hand, the acylphosphine oxide compound exhibits high compatibility with the polyfunctional (meth)acrylate having a hydroxyl group, and thus, diffuses uniformly in a medium, resulting in enhancing the sensitivity to an active energy ray.

Specific examples of the acylphosphine oxide compound include 2,4,6-trimethylbenzoyl-diphenyl-phosphine oxide, 2,6-dimethylbenzoyl-diphenyl-phosphine oxide, 2,6-dimethoxybenzoyl-diphenyl-phosphine oxide, benzoyl-diphenyl-phosphine oxide, 2,4,6-trimethylbenzoyl-bis(4-methoxyphenyl) phosphine oxide, 2,6-dimethylbenzoyl-bis(4-methoxyphenyl) phosphine oxide, 2,6-dimethoxybenzoyl-bis(4-methoxyphenyl) phosphine oxide, 2,4,6-trimethylbenzoyl-4-methoxyphenyl-phenyl-phosphine oxide, 2,6-dimethylbenzoyl-4-methoxyphenyl-phenyl-phosphine oxide, 2,6-dimethoxybenzoyl-4-methoxyphenyl-phenyl-phosphine oxide, 2,4,6-trimethylbenzoyl-dicyclohexyl-phosphine oxide, 2,6-dimethylbenzoyl-dicyclohexyl-phosphine oxide, 2,6-dimethoxybenzoyl-dicyclohexyl-phosphine oxide, benzoyl-bis(2,4,6-trimethylphenyl) phosphine oxide, bis(2,4,6-trimethylbenzoyl)-phenyl-phosphine oxide, bis(2,6-dimethylbenzoyl)-phenyl-phosphine oxide, bis(2,6-dimethoxybenzoyl)-phenyl-phosphine oxide, bis(2,4,6-trimethylbenzoyl)-2,4,4-trimethylpentyl-phosphine oxide, bis(2,6-dimethoxybenzoyl)-2,4,4-trimethylpentyl-phosphine oxide, bis(2,6-dimethylbenzoyl)-2,4,4-trimethylpentyl-phosphine oxide, and the like. Among these, 2,4,6-trimethylbenzoyl-diphenyl-phosphine oxide, bis(2,4,6-trimethylbenzoyl)-phenyl-phosphine oxide, and bis(2,6-dimethoxybenzoyl)-2,4,4-trimethylpentyl-phosphine oxide, which are easily available, are particularly preferable.

A printing ink according to the present invention contains the above-mentioned acylphosphine oxide compound preferably in an amount of 1 mass% or more, more preferably 3 mass% or more, still more preferably 5 mass% or more, because such an amount enhances the curing sensitivity to light emitted at 350 nm or more. In addition, the amount is preferably 20 mass% or less, more preferably 15 mass% or less, still more preferably 10 mass% or less, because such an amount enhances the storage stability of the ink and leads to retaining the fluidity well.

A printing ink according to the present invention can contain a sensitizing agent. Specific examples of the sensitizing agent include 2-methylthioxanthone, 2-chlorothioxanthone, 2,4-diethylthioxanthone, isopropylthioxanthone, 2,4-dichlorothioxanthone, 2,3-bis(4-diethylaminobenzal)cyclopentanone, 2,6-bis (4-dimethylaminobenzal)cyclohexanone, 2,6-bis(4-dimethylaminobenzal)-4-methylcyclohexanone, 4,4-bis(dimethylamino)-benzophenone (also known as Michler's ketone), 4,4-bis(diethylamino)-benzophenone, 4,4-bis(dimethylamino)chalcone, 4,4-bis(diethylamino)chalcone, p-dimethylaminocinnamylidene indanone, p-dimethylaminobenzylidene indanone, 2-(p-dimethylaminophenylvinylene)-isonaphthothiazole, 1,3-bis(4-dimethylaminobenzal)acetone, 1,3-carbonyl-bis(4-diethylaminobenzal)acetone, 3,3-carbonyl-bis(7-diethylaminocoumarin), N-phenyl-N-ethylethanolamine, N-phenylethanolamine, N-tolyldiethanolamine, isoamyl dimethylaminobenzoate, isoamyl diethylaminobenzoate, methyl diethylaminobenzoate, ethyl diethylaminobenzoate, isoamyl diethylaminobenzoate, 3-phenyl-5-benzoylthiotetrazole, 1-phenyl-5-ethoxycarbonyl thiotetrazole, and the like.

In cases where a sensitizing agent is added, the printing ink contains the sensitizing agent in an amount of preferably 0.1 mass% or more, more preferably 1 mass% or more, still more preferably 3 mass% or more, because such a printing ink can obtain good sensitivity. Additionally, from a viewpoint of enhancing the storage stability of the active energy ray-curable lithographic ink, the content is preferably 20 mass% or less of the active energy ray-curable lithographic ink, more preferably 15 mass% or less, still more preferably 10 mass% or less.

An ink according to the present invention preferably contains a polymerization inhibitor. Specific examples of polymerization inhibitors include hydroquinone, monoesterified products of hydroquinone, N-nitrosodiphenylamine, phenothiazine, p-t-butylcatechol, N-phenylnaphthylamine, 2,6-di-t-butyl-p-methyl phenol, chloranil, pyrogallol, and the like. In cases where such a polymerization inhibitor is added, the content is preferably 0.001 mass% or more of the active energy ray-curable lithographic ink from a viewpoint of enabling the active energy ray-curable lithographic ink to obtain good storage stability, and preferably 5 mass% or less from a viewpoint of obtaining good sensitivity.

A printing ink according to the present invention can contain one or more components selected from silicone fluids, alkyl (meth)acrylates, vegetable oils, fatty acid esters from vegetable oils, hydrocarbon solvents, and fluorocarbons. The ink preferably contains one or more components selected particularly from silicone fluids, alkyl (meth)acrylates, hydrocarbon solvents, and fluorocarbons.

The components have the effect of decreasing the adhesion of the ink to the silicone rubber which is the non-printing part of the waterless lithography plate. Presumably, the adhesion of the ink to the silicone rubber is decreased as follows. That is, the components in the ink diffuse from the ink upon contact of the components in the ink with the silicone rubber surface, and cover the silicone rubber surface in the form of a thin film. It is presumed that the thin film thus formed prevents the adhesion of the ink to the surface of the silicone rubber to prevent the scumming of the silicone rubber surface.

Among the components, the alkyl (meth)acrylate is cured by irradiation with an active energy ray, accordingly enhances sensitivity to the active energy ray simultaneously with enhancement of the water resistance of the ink-cured film, and thus, is preferable. Specific compounds to be used for the components are as below-mentioned.

Examples of silicone fluids include dimethyl silicone, methylphenylsilicone, alkyl-modified silicone, polyether-modified silicone, aralkyl-modified silicone, fatty acid amide-modified silicone, fatty acid ester-modified silicone, fluoroalkyl-modified silicone, methyl hydrogen silicone, silanol-modified silicone, alcohol-modified silicone, amino-modified silicone, epoxy-modified silicone, epoxy polyether-modified silicone, phenol-modified silicone, carboxy-modified silicone, mercapto-modified silicone, and the like.

Examples of alkyl(meth)acrylates include nonyl(meth)acrylate, decyl(meth)acrylate, undecyl(meth)acrylate, dodecyl(meth)acrylate, tridecyl (meth)acrylate, tetradecyl (meth)acrylate, pentadecyl(meth)acrylate, hexadecyl(meth)acrylate, heptadecyl(meth)acrylate, octadecyl(meth)acrylate, isooctadecyl(meth)acrylate, and the like. Such an alkyl(meth)acrylate preferably has an alkyl group having 5 to 24 carbon atoms, more preferably 6 to 21 carbon atoms.

Examples of vegetable oils include soybean oil, linseed oil, safflower oil, tung oil, tall oil, dehydrated castor oil, and the like.

Examples of fatty acid esters from vegetable oils include esters of a fatty acid having an alkyl main chain containing approximately 15 to 20 carbon atoms, such as a stearic acid, isostearic acid, hydroxystearic acid, oleic acid, linoleic acid, linolenic acid, or eleostearic acid with a $C_{1-10}$ alkyl such as methyl, ethyl, propyl, isopropyl, butyl, isobutyl, tert-butyl, or 2-ethylhexyl.

Examples of hydrocarbon solvents include polyolefin oil, naphthene oil, paraffin oil, and the like.

Examples of fluorocarbons include 1,1,1,2,2-pentafluoroethane, 1,1,1,2,2,3,3,4,4-nonafluorobutane, 1,1,1,2,2,3,3,4,4,5,5,6,6-tridecafluorohexane, 1,1,1,2,2,3,3,4,4,5,5,6,6,7,7,8,8-heptadecafluorooctane, 1,1,1,2,3,3,3-heptafluoropropane, 1,1,1,2,3,3,4,4-octafluoro-2-trifluoromethylbutane, 1,1,1,2,3,3,4,4,5,5,6,6-dodecafluoro-2-trifluoromethyl hexane, 1,1,2,2-tetrafluoroethane, 1,1,2,2,3,3,4,4-octafluorobutane, 1,1,2,2,3,3,4,4,5,5,6,6-dodecafluorohexane, and the like.

From a viewpoint of enhancing the anti-scumming, a printing ink according to the present invention preferably contains one or more components selected from the above-mentioned silicone fluids, vegetable oils, fatty acid esters from vegetable oils, hydrocarbon solvents, and fluorocarbons in an amount of 0.5 mass% or more. The content is more preferably 1 mass% or more, and still more preferably 2 mass% or more. In addition, the content is preferably 10 mass% or less, because such a content makes it possible to enhance the storage stability of the active energy ray-curable lithographic ink. The content is more preferably 8 mass% or less, still more preferably 5 mass% or less.

A printing ink according to the present invention preferably contains a pigment dispersant in order to enhance the dispersibility of the pigment. The optimal amount of such a pigment dispersant varies depending on the density, particle diameter, surface area, and the like of the pigment to be used, but the pigment dispersant acts on the surface of the pigment to inhibit the aggregation of the pigment. This enhances the pigment dispersibility to enhance the fluidity of the active energy ray-curable lithographic ink.

Specific examples of the pigment dispersant include "Anti-Terra-U", "Anti-Terra-203/204", "Disperbyk-101, 102, 103, 106, 107, 110, 111, 115, 118, 130, 140, 142, 145, 161, 162, 163, 164, 165, 166, 167, 168, 170, 171, 174, 180, 181, 182, 184, 185, 187, 190, 191, 192, 193, 199, 2000, 2001, 2008, 2009, 2010, 2012, 2013, 2015, 2022, 2025, 2026, 2050, 2055, 2060, 2061, 2070, 2096, 2150, 2151, 2152, 2155, 2163, 2164, 2200, 2205, 9067, 9076", "Bykumen", "BYK-P104, P105", "P104S, 240S", and "Lactimon", which are manufactured by BYK Chemie.

Here, "Bykumen" and "Lactimon" are registered trademarks.

Other examples include: "EFKA 44, 46, 47, 48, 49, 54, 63, 64, 65, 66, 71, 701, 764, 766" and "EFKA POLYMER 100, 150, 400, 401, 402, 403, 450, 451, 452, 453, 745" manufactured by Efka Chemicals B.V.; "FLOWLEN TG-710, "FLOWNON SH-290, SP-1000", and "POLYFLOW No.50E, No.300" manufactured by Kyoeisha Chemical Co., Ltd.; and "DISPARLON 325, KS-860, 873SN, 874, 1401, #2150, #7004" manufactured by Kusumoto Chemicals, Ltd.

Here, "EFKA", "FLOWLEN", "FLOWNON", and "DISPARLON" are registered trademarks.

Further examples include: "DEMOLR N, N, MS, C, S N-B, EP", "HOMOGENOL L-18, "EMULGEN 920, 930, 931, 935, 950, 985", and "ACETAMIN 24, 86" manufactured by Kao Corporation; "SOLSPERSE 5000, 13940, 17000, 24000GR, 32000, 33000, 39000, 41000, 53000" manufactured by Avecia Inc.; "AJISPERPB 821, 822, 824" manufactured by Ajinomoto Fine-Techno Co., Inc.; and the like.

Here, "DEMOL", "HOMOGENOL", "EMULGEN", "ACETAMIN", "SOLSPERSE", and "AJISPER" are registered trademarks.

The amount of the pigment dispersant is preferably 5 mass% or more and 50 mass% or less with respect to the pigment because such an amount enhances the fluidity of the active energy ray-curable lithographic ink.

If desired, a printing ink according to the present invention can contain an additive such as a wax, antifoaming agent, transfer improving agent, or leveling agent.

The viscosity of a printing ink according to the present invention is measured at 35°C using a cone-plate rotating viscometer. Such a cone-plate rotating viscometer has a structure including a cone and a plate that are shaped such that the top of the cone is vertically in point contact with the flat face of the plate. A measurement sample is sandwiched between the cone and the plate face, and a viscosity is measured on the basis of a torque applied to the cone while the cone is rotating.

The viscosity (A) at a rotational speed of 0.5 rpm is preferably 5 Pa·s or more and 100 Pa·s or less. With the viscosity (A) of 5 Pa·s or more, the ink tends to exhibit a good transfer property between rollers. The viscosity (A) is more preferably 10 Pa·s or more, and still more preferably 20 Pa·s or more. Additionally, with the viscosity (A) of 100 Pa·s or less, the ink has good fluidity, and a white ink in particular exhibits enhanced masking properties. The viscosity (A) is more preferably 80 Pa s or less, still more preferably 60 Pa s or less.

In addition, the viscosity (B) at a rotational speed of 50 rpm is preferably 10 Pa·s or more and 40 Pa·s or less. The viscosity (B) of 10 Pa·s or more makes it possible to enhance the anti-scumming of the ink. The viscosity (B) is more preferably 15 Pa·s or more, still more preferably 20 Pa·s or more. With the viscosity (B) of 40 Pa·s or less, the transfer of the ink onto the lithography plate (the ink transfer onto the printing part) is enhanced. The viscosity (B) is more preferably 35 Pa·s or less, still more preferably 30 Pa·s or less.

In addition, the viscosity (C) at a rotational speed of 20 rpm is preferably 10 Pa·s or more and 40 Pa·s or less. The viscosity (C) of 10 Pa·s or more makes it possible to enhance the anti-scumming of the ink. The viscosity (C) is more preferably 15 Pa·s or more, still more preferably 20 Pa·s or more. With the viscosity (C) of 40 Pa·s or less, the transfer of the ink onto the lithography plate (the ink transfer onto the printing part) is enhanced. The viscosity (C) is more preferably 35 Pa·s or less, still more preferably 30 Pa·s or less.

The viscosity ratio (B)/(A), which is the ratio of the viscosity (B) to the viscosity (A), is preferably 0.25 or more and 0.4 or less. The viscosity ratio (B)/(A) is more preferably 0.30 or more and 0.4 or less, still more preferably 0.35 or more and 0.4 or less. The viscosity ratio (B)/(A) within the above-mentioned range enables the ink to have both anti-scumming and fluidity, and using such an ink makes it possible to obtain a printed material that has no scumming, yields a smooth printing part, and thus has high quality.

The viscosity ratio (B)/(C), which is the ratio of the viscosity (B) to the viscosity (C), is preferably 0.60 or more and 1.00 or less. The viscosity ratio (B)/(C) is more preferably 0.70 or more and 1.00 or less, still more preferably 0.80 or more and 1.00 or less. The viscosity ratio (B)/(C) within the above-mentioned range makes it possible to achieve stable performance for wide ranges of printing speeds and printing conditions, and obtain a printed material having no scumming and having good quality.

A printing ink according to the present invention preferably contains a surfactant. The active energy ray-curable lithographic ink containing a surfactant makes it possible that the ink takes in a suitable amount (generally said to be 10 to 20 mass% of the total amount of the ink) of dampening water, for example, during water lithography, and is emulsified, thus increasing the repellency of the non-printing part against the dampening water to thereby enhance the anti-scumming of the ink.

The ratio of the hydrophilic group to the hydrophobic group in the surfactant is represented by an HLB value. The "HLB value" as used herein is a value indicating the degree of the affinity with the water and oil of the surfactant. This HLB value is a value of 0 to 20, and the value near 0 represents a higher oleophilicity while a value near 20 represents a higher hydrophilicity. The HLB value of the surfactant is preferably 8 or more, more preferably 10 or more, from a viewpoint of dissolving water. In addition, the HLB value is preferably 18 or less, more preferably 16 or less, from a viewpoint of dissolving in the active energy ray-curable lithographic ink.

Specific examples of the surfactant include polyoxyethylene alkyl ether, polyoxyethylene lauryl ether, polyoxyethylene oleyl ether, polyoxyethylene stearyl ether, polyoxyethylene cetyl ether, polyoxyethylene palmityl ether, polyoxypropylene alkyl ether, polyoxypropylene lauryl ether, polyoxypropylene oleyl ether, polyoxypropylene stearyl ether, polyoxypropylene cetyl ether, polyoxypropylene palmityl ether, polyoxyalkylene alkyl ether, polyoxyalkylene lauryl ether, polyoxyalkylene oleyl ether, polyoxyalkylene stearyl ether, polyoxyalkylene cetyl ether, and polyoxyalkylene palmitylether; mono-, di-, and trialkyl ether of sorbitan acid, mono-, di-, and trilauryl ether of sorbitan acid, mono-, di-, and trioleyl ether of sorbitan acid, mono-, di-, and tristearyl ether of sorbitan acid, mono-, di-, and tricetyl ether of sorbitan acid, mono-, di-, and tripalmityl ether of sorbitan acid; mono-, di-, and trialkyl ether of polyoxyethylene of sorbitan acid, mono-, di-, and trilauryl ether of polyoxyethylene of sorbitan acid, mono-, di-, and trioleyl ether of polyoxyethylene of sorbitan acid, mono-, di-, and tristearyl ether of polyoxyethylene of sorbitan acid, mono-, di-, and tricetyl ether of polyoxyethylene of sorbitan acid, and mono-, di-, and tripalmityl ether of polyoxyethylene of sorbitan acid; and polyether-modified silicone oil. Surfactants having an HLB value of 8 or more and 18 or less are preferably used.

In cases where a printing ink according to the present invention is used for water lithography, the amount of the surfactant in the ink is preferably 0.01 mass% or more, more preferably 0.05 mass% or more, still more preferably 0.1 mass% or more, because such an amount allows the ink to take in the dampening water to exhibit stabilized emulsification. In addition, the amount is preferably 5 mass% or less, more preferably 3 mass% or less, still more preferably 1 mass% or less, so as not to make it possible that the printing ink takes in too much dampening water during printing to thereby be dissolved mutually with the dampening water.

A printing ink according to the present invention preferably has an ink tack value of 5.0 or more because such an ink tack value leads to retaining ink transfer to a printing substrate. In addition, the ink tack value is preferably 18.0 or less, more preferably 15.0 or less, still more preferably 12.0 or less, because such an ink tack value makes it possible to obtain a printed material having excellent positional accuracy. In this regard, the ink tack value is an index that represents the stickiness of an ink, and is measured using an incometer.

A printing ink according to the present invention exhibits good adhesion to a plastic film, achieves an excellent effect that does not decrease the adhesion capability during hot-water treatment, and thus, is a successful solution to a conventional active energy ray-curable lithographic ink that provides insufficient adhesion between the ink and the surface of a substrate such as a plastic film. That is, a printing ink according to the present invention can be suitably used as an active energy ray-curable lithographic ink.

Next, a method of producing a printing ink according to the present invention will be described.

A printing ink according to the present invention is obtained by dissolving (a) a urethane acrylate, a resin such as (b) a resin having an ethylenically unsaturated group and a hydrophilic group, (c) a polymerizable monomer, preferably a pigment, and another component with optional heating at 5 to 100°C, and homogeneously mixing and dispersing these components using an agitator or kneading machine such as a kneader, three-roll mill, ball mill, planetary ball mill, beads mill, roll mill, attritor, sand mill, gate mixer, paint shaker, homogenizer, or planetary centrifugal mixer. Optional defoaming under vacuum or reduced pressure after or during the mixing and dispersion is also preferable.

A method of producing a printed material using a printing ink according to the present invention will be described. First, a printed material having an ink coating can be obtained by a step of applying a printing ink according to the present invention onto a substrate to be printed by lithography.

Examples of substrates include art paper, coat paper, cast paper, synthetic paper, newsprint, aluminium-vapor-deposited paper, metal, a plastic film, and the like. A printing ink according to the present invention has excellent transfer to a plastic film, and thus, a plastic film is preferably used as a substrate. In addition, a plastic-film-laminated paper in which a plastic film is laminated on paper, a metal-vapor-deposited plastic film in which metal such as aluminium, zinc, or copper is vapor-deposited on a plastic, or the like can be preferably used. Examples of the plastic film include polyethylene terephthalate, polyethylenes, polyesters, polyamides, polyimides, polystyrenes, polypropylenes, polycarbonates, polyvinyl acetals, and the like. Among these, at least one selected from the group consisting of polypropylenes, polyethylenes, polyesters, and polyamides, particularly a material containing a polypropylene provides good transfer of an ink according to the present invention, and thus, is preferable.

In addition, such a plastic film preferably undergoes a surface treatment such as primer resin coating, corona discharge treatment, or plasma treatment in order to become adhesive.

In a method of producing a printed material according to the present invention, a substrate the printing side surface of which has a nitrogen element concentration of 0.5 atom% or more and 10.0 atom% or less is preferably used. An intermolecular force such as hydrogen bonding exists between a functional group present in the surface of a substrate and derived from a compound containing a nitrogen atom in an amino group or the like and, in particular, both of the following: the resin having a hydrophilic group and the polyfunctional (meth)acrylate in the ink. Such an intermolecular force makes it possible to enhance the transfer of the ink and the adhesion between the ink and the substrate, and thus, the nitrogen element concentration is preferably 0.5 atom% or more. In addition, the concentration is preferably 10.0 atom% or less because such a concentration prevents yellowing due to irradiation with an active energy ray, long-time exposure to ultraviolet light, or the like.

In the present invention, the nitrogen element concentration of the surface of the substrate is the average nitrogen element concentration of the surface of the substrate, and can be measured by a common composition analysis technique such as X-ray photoelectron spectroscopy (XPS) or Rutherford backscattering spectrometry (RBS). A preferable analysis method is X-ray photoelectron spectroscopy in which the excitation X-ray is a monochromatic Al K$\alpha$1,2 ray, the X-ray diameter is 200 $\mu$m, and the photoelectron take-off angle, that is, the slope of the detector with respect to the surface of the film is 45° or 60°. The slope of the detector can be suitably selected in accordance with the film thickness of the below-mentioned easily adhesive layer.

According to a method of producing a printed material according to the present invention, the printing side surface of the substrate preferably has an easily adhesive layer containing an organic material. An intermolecular force such as hydrogen bonding exists between a functional group present in an easily adhesive layer and derived from an organic material and, in particular, both of the following: the resin having an acidic group and the polyfunctional (meth)acrylate in the ink. Such an intermolecular force makes it possible to enhance the transfer of the ink and the adhesion between the ink and the substrate.

The easily adhesive layer preferably contains at least one compound selected from amines, amides, isocyanates, and urethanes. Among these, it is preferable to have at least a urethane structure because having a urethane bond makes it possible to form a hard segment in the easily adhesive layer and form a coating having a high cohesive force, and in addition, because the hydrogen bonding strength of the urethane bond makes it possible to enhance the adhesive force of the ink.

Examples of an amine in the easily adhesive layer include: ethylenediamine; propylenediamine; hexamethylenediamine; phenylenediamine; tolylenediamine; diphenyldiamine; diaminodiphenylmethane; diaminodiphenylmethane; diaminocyclohexylmethane; ethylenediaminetetraacetic acid; N,N-dialkylaminoalkyl (meth)acrylates such as N,N-dimethylaminoethyl (meth)acrylate, N,N-diethylaminoethyl (meth)acrylate, and N,N-dimethylaminopropyl (meth)acrylate; (meth)acryloyloxyalkyltrialkylammonium salts such as 2-(methacryloyloxy)ethyltrimethylammonium chloride, 2-(methacryloyloxy)ethyltrimethylammonium bromide, and 2-(methacryloyloxy)ethyltrimethylammoniumdimethyl phosphate; (meth)acryloylaminoalkyltrialkylammonium salts such as methacryloylaminopropyltrimethylammonium chloride and methacryloylaminopropyltrimethylammonium bromide; tetraalkyl (meth)acrylates such as tetrabutylammonium (meth)acrylate; trialkylbenzylammonium (meth9 acrylate such as trimethylbenzylammonium (meth)acrylate; and the like.

Examples of an amide in the easily adhesive layer include: aliphatic amides such as ethylenebisstearic acid amide and hexamethylenebisstearic acid amide; N,N-dialkylaminoalkyl (meth)acrylamide such as N,N-dimethylaminoethyl (meth)acrylamide, N,N-diethylaminoethyl (meth)acrylamide, and N,N-dimethylaminopropyl (meth)acrylamide; and the like. Examples of isocyanates include: tolylene diisocyanate, diphenylmethane-4,4'-diisocyanate, metaxylylene diisocyanate, hexamethylene-1,6-diisocyanate, 1,6-diisocyanate hexane, adducts of tolylene diisocyanate and hexanetriol, adducts of tolylene diisocyanate and trimethylolpropane, polyol-modified diphenylmethane-4,4'-diisocyanate, carbodiimide-modified diphenylmethane-4,4'-diisocyanate, isophorone diisocyanate, 1,5-naphthalene diisocyanate, 3,3'-bitolylene-4,4'diisocyanate, 3,3'dimethyldiphenylmethane-4,4'-diisocyanate, metaphenylene diisocyanate, and the like.

Examples of an isocyanate in the easily adhesive layer include: aromatic diisocyanates such as tolylene diisocyanate and diphenylmethane-4,4-diisocyanate; aromatic aliphatic diisocyanates such as xylylene diisocyanate; alicyclic diisocyanates such as isophorone diisocyanate, 4,4-dicyclohexylmethane diisocyanate, and 1,3-bis(isocyanatemethyl)cyclohexane; aliphatic diisocyanates such as hexamethylene diisocyanate and 2,2,4-trimethylhexamethylene diisocyanate; polyisocyanates obtained by preliminarily adding one or more of these compounds to trimethylolpropane or the like; and the like. These may be used singly or in mixture of two or more kinds thereof. For example, the cases where the surface layer contains an amine compound and an isocyanate compound encompass cases where any one compound in the surface layer contains an amine group and an isocyanate group.

A urethane to be used in the easily adhesive layer may be obtained, for example, by polymerizing a polyol and an isocyanate compound by a known method. The constituent components can include at least a polyol and an isocyanate compound, and further include a chain extender, if desired. Examples of polyols include: polyester polyols obtained by reaction between a polyvalent carboxylic acid (for example, a malonic acid, succinic acid, adipic acid, sebacic acid, fumaric acid, maleic acid, terephthalic acid, or isophthalic acid) or an acid anhydride thereof and a polyhydric alcohol (for example, ethylene glycol, diethylene glycol, triethylene glycol, propylene glycol, butanediol, 1,3-butanediol, 1,4-butanediol, 2,3-butanediol, neopentyl glycol, 1,6-hexanediol, or the like); polyether polyols such as polyethylene glycol, polypropylene glycol, polyethylene propylene glycol, polytetramethylene ether glycol, and polyhexamethylene ether glycol; polycarbonate polyols; polyolefin polyols; acrylpolyols; and the like.

Without particular limitation, the amount of an amine, amide, isocyanate, and urethane to be contained in the easily adhesive layer is preferably 0.1 mass% or more and 80 mass% or less, more preferably 1.0 mass% or more and 50 mass% or less, particularly preferably 5 mass% or more and 20 mass% or less, with respect to 100 mass% of the whole easily adhesive layer.

The easily adhesive layer may further contain a resin component. Such a resin component is not limited to any particular resin component provided that the resin component has adhesiveness to the substrate. Such a resin component that can be suitably used is, for example, a polyester, polycarbonate, epoxy resin, alkyd resin, acrylic resin, urea resin, or the like. Such a resin component to be used is preferably a polyester or an acrylic resin, and particularly preferably a polyester having a phthalic acid skeleton. In addition, the above-mentioned urethanes may be those contained as urethane resins. In addition, two or more different resins may be used in combination.

The easily adhesive layer may suitably contain any kind of additive such as a cross-linking agent, plasticizer, heat-resistant stabilizer, weather-resistant stabilizer, organic or inorganic microparticles, waxing agent, antioxidant, weathering agent, antistatic agent, or pigment to the extent that such an additive does impair the film characteristics. Examples of cross-linking agents that can be used include melamine cross-linking agents, aziridine cross-linking agents, epoxy cross-linking agents, methylolated or alkylolated urea cross-linking agents, acrylamide cross-linking agents, polyamide cross-linking agents, oxazoline cross-linking agents, carbodiimide cross-linking agents, isocyanate cross-linking agents, various silane coupling agents, various titanate coupling agents, and the like.

The thickness of the easily adhesive layer can be suitably adjusted in accordance with the optical characteristics and productivity, and is preferably 10 nm or more and 5000 nm or less. The thickness is more preferably 50 nm or more and 3000 nm or less, particularly preferably 100 nm or more and 1000 nm or less. The thickness of 10 nm or more enables uniform coating without causing any defect on the substrate, and makes it possible to provide uniform adhesion. In addition, the thickness of 5000 nm or less makes it possible to decrease an adverse effect on the optical characteristics.

The thickness of the substrate to be used in flexible packaging applications is preferably 5 $\mu$m or more, more preferably 10 $\mu$m or more, from a viewpoint of the mechanical strength of the substrate desired for printing. In addition, the thickness is preferably 50 $\mu$m or less, more preferably 30 $\mu$m or less, which makes the cost of the substrate low.

Examples of methods that can be used for applying a printing ink according to the present invention to a substrate include known methods such as flexography, offset printing, gravure printing, screen printing, bar coater, and the like. In particular, lithography is preferable. The lithographic method encompasses water lithography and waterless lithography, either of which can be used. Waterless printing does not use dampening water, accordingly improves the reproducibility of the printing halftone dots, thus makes it possible to print a high-definition picture, and in addition, serves as an excellent printing system in terms of an environmental burden. The substrate can be used in the form of either a sheet or a roll film. For printing on a thin film for flexible packaging, it is preferable to perform roll-to-roll printing using a roll film.

A lithography plate to be used for printing a printing ink according to the present invention can be a waterless lithography plate coated with silicone rubber. The amount of this silicone rubber layer to be formed before development is preferably 2.6 g/m$^2$ or more, more preferably 3.0 g/m$^2$ or more, because such an amount affords good anti-scumming and printing resistance that makes it possible to produce a large number of processed prints in one printing step. In addition, the amount is preferably 8.0 g/m$^2$ or less, more preferably 6.5 g/m$^2$ or less, to obtain good image reproducibility. Applying the silicone rubber layer in an amount within the above-mentioned range enables a large amount of printing without scumming, and in addition, makes it possible to obtain a printed material having good image reproducibility.

The thickness of the ink coating (ink-cured film) on a printed material is preferably 0.1 to 50 $\mu$m. The ink coating having a thickness within this range makes it possible to maintain good printing quality, and at the same time, reduce ink cost.

In addition, transferring ink to a substrate for printing can be followed by a step of further irradiating the ink coating printed on the substrate with an active energy ray. Irradiation with an active energy ray enables the ink coating on a printed material to be cured instantly. The active energy ray to be used may be any ray as long as such a ray has an excited energy desired for the curing reaction, and preferable examples include ultraviolet light and electron beams. Using an electron beam makes it possible to cure the coating without having a photopolymerization initiator in the ink, and thus, is particularly suitable in applications in which it is desirable to avoid migration of a low-molecular-weight compound into the contents of a pharmaceutical package, a food package, or the like. In cases where the coating is cured by using an electron beam, an electron beam apparatus emitting an energy ray of 100 to 500 keV is preferably used.

The irradiation amount of an electron beam is preferably 5 kGy or more, more preferably 10 kGy or more, still more preferably 20 kGy or more, because such an irradiation amount leads to securing good curability for the ink coating. In addition, the amount is preferably 80 kGy or less, more preferably 50 kGy or less, because such an amount prevents the printing substrate from being deteriorated or discolored by irradiation with an electron beam. In this regard, the acceleration voltage that contributes to the depth of penetration of an electron beam is desirably 80 kV or more and 300 kV or less.

In cases where ultraviolet light is used for curing, an ultraviolet light irradiation device such as a high-pressure mercury lamp, xenon lamp, metal halide lamp, or light-emitting diode (LED) is preferably used. Using a light-emitting diode that emits a bright line having a wavelength of 350 to 420 nm is preferable from viewpoints of power saving and cost reduction.

A printed material according to the present invention preferably contains at least a substrate, a printing ink according to the present invention, an adhesive, and a hotmelt film called a sealant film. Examples of such sealant films include, but are not limited particularly to: an unstretched polypropylene film (CPP) and a linear low-density polyethylene film (LLDPE) that each have a thickness of 20 to 120 $\mu$m; and the like. This sealant film serves to form a pouch for packing contents, wherein the pouch is formed in such a manner that the outer periphery of the printed material is heat-sealed with the sealant film portions opposed to form a bag. In addition, selecting the material and thickness of the sealant film suitably makes it possible to protect the contents and retain the properties that can undergo the following steps.

With the printed material laminate, it is possible to include a hot-water treatment step after formation of the laminate. Examples of this hot-water treatment step include: a boiling treatment generally performed in a normal-pressure environment at 100°C or less; and a retorting treatment performed under a pressurized environment at 100°C or more. A retorting treatment is often performed in a pressurized environment at 120°C. There are conventionally some cases where such a hot-water treatment step leads to decreasing the adhesive strength between the substrate and the printing ink, but a printing ink according to the present invention makes it possible to obtain a printed material the adhesion capability of which is not decreased during hot-water treatment. The adhesive strength of a printed material according to the present invention is preferably 1.0 N/15 mm or more, more preferably 1.5 N/15 mm or more, still more preferably 2.0 N/15 mm or more, still more preferably 3.0 N/15 mm or more, or the failure mode is substrate failure (that is, substrate failure occurs earlier than peeling).

EXAMPLES

Below, the present invention will be specifically described with reference to Examples. However, the present invention is not limited thereto.

<Measurement methods and evaluation methods>

(1) Measurement of weight-average molecular weight

The weight-average molecular weight of a resin was measured by gel permeation chromatography (GPC) using tetrahydrofuran for the mobile phase. The GPC device was HLC-8220 (manufactured by Tosoh Corporation). The column used was composed of TSKgel SuperHM-H (manufactured by Tosoh Corporation), TSKgel SuperHM-H (manufactured by Tosoh Corporation), and TSKgel SuperH2000 (manufactured by Tosoh Corporation), which were connected in this order. The RI detector used for measurement was an RI detector built in the GPC device. A calibration curve was prepared using polystyrene as a standard material, and used to calculate the weight-average molecular weight of a sample. A method of preparing a measurement sample will be described. A sample was diluted with tetrahydrofuran so as to have a concentration of 0.25 mass%. The dilute solution was stirred and dissolved using a mixing rotor (MIX-ROTAR VMR-5, manufactured by As One Corporation) at 100 rpm for five minutes, and filtrated through a 0.2 $\mu$m filter (Z227536-100EA, manufactured by Sigma-Aldrich Co. LLC.). The filtrate was used as a measurement sample.

The measurement conditions will be described. In the measurement, the injection volume was 10 $\mu$L, the analysis time was 30 minutes, the flow rate was 0.4 mL/min, and the column temperature was 40°C.

(2) Evaluation of adhesion

Ink was transferred to a substrate film using an RI tester PI-600 (manufactured by Tester Sangyo Co., Ltd.) so as to have a coating amount of 1 g/m$^2$, and irradiated with an electron beam using an electron beam irradiation device EC250/30/90LS manufactured by Iwasaki Electric Co., Ltd. (at an acceleration voltage of 125 kV and in an irradiation amount of 30 kGy) at a belt conveyor speed of 9 m/minute to obtain a substrate film having an ink-cured film. In this regard, when the irradiation amount of the electron beam was less than 5 kGy, the ink had insufficient curability, and the cured film had tack remaining. When the irradiation amount of the electron beam was larger than 80 kGy, the substrate film exhibited yellowing. An adhesive TAKELAC A-626/TAKENATE A-65 (mixed at a mass ratio of 16/1, manufactured by Mitsui Chemicals, Inc.) was applied to the ink-cured film using a bar-coat method to form a coating in such a manner that the coating amount became 4.0 g/m$^2$ after drying at 80°C for one minute. The adhesive-coated substrate film and a linear low-density polyethylene LL-XHT50 (having a thickness of 50 $\mu$m, manufactured by Futamura Chemical Co., Ltd.) as a sealant were laminated onto each other using a hand roller, and then underwent aging at 40°C for 72 hours to obtain a film laminate composed of a sealant/adhesive/ink-cured film/substrate film. "TAKELAC" and "TAKENATE" are registered trademarks.

Two film laminates (square, 10 cm $\times$ 10 cm) were provided as above-mentioned, and then layered one on the other in such a manner that the respective sealants were in contact with each other. Three of the four ends were processed by sealing using a heat sealer TP-701-B (manufactured by Tester Sangyo Co., Ltd.) at a heater temperature of 180°C and a pressure of 0.1 MPa for 1.0 second to produce a bag with one end opened. Adding 50 ml of pure water into this bag was followed by removing air sufficiently and sealing the remaining one end using the sheet sealer to obtain a pouch formed of a film laminate containing pure water thereinside.

The pouch was placed in a water bath set to 95°C, and underwent hot-water treatment for 30 minutes. After the hot-water treatment, the sealed portions were cut off from the pouch, and the water inside was removed to obtain a hot-water-treated film laminate.

Sections having a width of 15 mm and a length of 50 mm were cut out of the film laminate before and after the hot-water treatment.

A TENSILON universal material testing instrument (model number "RTG-1210", manufactured by A&D Company, Limited) was used to perform a peel strength measurement in accordance with the 90° T-peel Test method (JIS K 6854-3) with the substrate film and the sealant both sandwiched between the upper and lower chucks. The load value at the first maximum point was regarded as a laminate peel strength. The testing environment had an atmospheric temperature of 25°C and a humidity of 50%, and the testing speed was 300 mm/minute.

The main failure mode in each of Examples and Comparative Examples was interfacial peeling between the substrate film and the ink, and in Tables, the occurrence of the substrate failure is represented by an asterisk ("*").

(3) Compatibility

In accordance with the formulation mentioned in each of Examples and Comparative Examples, a urethane (meth)acrylate mentioned in each of Examples and Comparative Examples was added to a resin varnish obtained using a resin, polymerizable monomer 1, polymerizable monomer 2, and polymerization inhibitor listed in each of Examples and Comparative Examples With the resulting coating liquid, the appearance which was completely transparent and very good was rated SS, that which was transparent and good was rated S, that which was generally transparent and good was rated A, that which was a little turbid but practically unproblematic was rated B, and that which was turbid was rated C.

(4) Viscosity

The viscosity of an ink was measured at 35°C using a cone-plate rotating viscometer having a cone diameter of 40 mm and an inclination angle of 1.0°.

(5) Appearance of coating

The coating appearance of a printed material produced using an RI tester PI-600 (manufactured by Tester Sangyo Co., Ltd.) was evaluated by visual observation. The coating which had a poor appearance such as printing unevenness was rated A, that which had a little poor but practically unproblematic appearance was rated B, and that which exhibited a markedly poor appearance was rated C.

(6) Tack value

The ink produced was applied in an amount of 1.3 ml to a roller incometer INKOGRAPH TYPE-V (manufactured by Tester Sangyo Co., Ltd.), which was operated at a roller temperature of 38°C and a rotational speed of 400 rpm. After one minute, the tack value was measured.

(7) Anti-scumming

The ink in each of Examples and Comparative Examples was placed in an amount of 0.5 g onto a roller RI testerPI-600 (manufactured by Tester Sangyo Co., Ltd.), and transferred to a non-printing part of a waterless lithography plate TAC-VG-5 (manufactured by Toray Industries, Inc.). Furthermore, the ink transferred was transferred to a sheet of white coat paper, and the color density was measured using a reflection densitometer SpectroEye (manufactured by GretagMacbeth GmbH). A color density of less than 0.1 afforded the anti-scumming that was particularly good and rated S, 0.1 or more and less than 0.2 afforded that which was good and rated A, 0.2 or more and less than 0.3 afforded that which was acceptable and rated B, and 0.3 or more afforded that which was rated C.

(8) Evaluation of ink transfer

A waterless lithography plate (TAC-VG5, manufactured by Toray Industries, Inc.) was attached onto a web rotary offset press (CI-8, manufactured by Comexi Group Industries S.A.U.), in which waterless lithography plate, a strip-shaped solid image 400 mm in length (in the printing direction) × 900 mm in width (across the printing direction) was provided in the center of a printing plate 854 mm in length (in the printing direction) × 1,070 mm in width (across the printing direction). The ink mentioned in each of Examples and Comparative Examples was used to perform printing 1,000 m on a polyester film PTM12 (having a thickness of 12 $\mu$m, manufactured by Unitika Ltd.) at a printing speed of 200 m/minute and in an ink supply amount of 50%. Using a reflection densitometer (SpectroEye, status E, manufactured by GretagMacbeth GmbH), the reflection density of the solid portion was evaluated with high-quality paper regarded as paper white (a reference having a reflection density of 0). A higher reflection density of the solid portion represents better transfer.

(9) Urethane bond fraction

Measurements were taken under the below-mentioned conditions using proton magnetic resonance (H-NMR).

Device: ECZ600R (manufactured by JEOL Ltd.)
Observation frequency: 600 MHz
Cumulated number of times: 512 times
Temperature: 20°C
Sample composition: 10 mg of urethane acrylate. 1000 mg of N,N-dimethylformamide-d7 (deuterated solvent). 5 mg of 3,5-dinitrobenzoic acid (internal standard material)

The mass of urethane acrylate in the measurement sample was normalized to a (g), the mass of the internal standard material was normalized to A (g), and the value of integral of the signal derived from the C-H of the internal standard material was normalized to 1. On the basis of this, the value of integral of the signal derived from the N-H of the urethane bond was assumed to be b, and the molecular weights of the urethane bond and the internal standard material were assumed to be 59.0 and 212.1 respectively. The urethane bond fraction (mass%) was determined in accordance with the mathematical formula (1).

[Math. 1]

$$(\text{Urethane bond fraction}) \quad = \frac{3 \times A \times b \times 59.0}{212.1 \times a} \times 100 \qquad (1)$$

<Substrate film>

The substrate films listed in Tables are as follows:

PA: polyamide film ONM15 (having a thickness of 15 $\mu$m, manufactured by Unitika Ltd.)
OPP: polypropylene film P2111 (having a thickness of 20 $\mu$m, manufactured by Toyobo Co., Ltd.)
PET: a polyester film having a urethane-bond-containing easily adhesive layer (having a thickness of 12 $\mu$m)

<Raw materials for ink>

(Urethane (meth)acrylate)

Substances having the below-mentioned composition were used as urethane (meth)acrylates.
Urethane acrylate 1: a urethane acrylate composed of an alicyclic diisocyanate (hydrogenated XDI), carboxylic acids (isophthalic acid and adipic acid), a polyol, and 2-hydroxyethyl acrylate, having a weight-average molecular weight (Mw) of 3600, and having a urethane bond fraction of 8 mass%.
Urethane acrylate 2: a urethane acrylate composed of an aromatic diisocyanate (TDI) and a polyfunctional acrylate having a hydroxyl group (pentaerythritol triacrylate), and having an Mw of 850 and a urethane bond fraction of 14 mass%.
Urethane acrylate 3: a urethane acrylate composed of an alicyclic diisocyanate (IPDI), a polyether polyol (polytetramethylene ether glycol), and 2-hydroxyethyl acrylate, and having an Mw of 3300 and a urethane bond fraction of 15 mass%.
Urethane acrylate 4: a urethane acrylate composed of an alicyclic diisocyanate (IPDI), a polyether polyol, and 2-hydroxyethyl acrylate, and having an Mw of 13000 and a urethane bond fraction of 4 mass%.
Urethane acrylate 5: a urethane acrylate composed of an alicyclic diisocyanate (IPDI), a polyester polyol, and 2-hydroxyethyl acrylate, and having an Mw of 3800 and a urethane bond fraction of 13 mass%.
Urethane acrylate 6: a urethane acrylate composed of an alicyclic diisocyanate (IPDI), a polyester polyol (polypropylene glycol), and 2-hydroxyethyl acrylate, and having an Mw of 2000 and a urethane bond fraction of 17 mass%.

Urethane acrylate 7: a urethane acrylate composed of an alicyclic diisocyanate (IPDI), a polyether polyol, and 2-hydroxyethyl acrylate, and having an Mw of 8600 and a urethane bond fraction of 8 mass%.

(Resin)

Resin 1: this resin 1 having an ethylenically unsaturated group and a hydrophilic group was obtained by allowing 0.55 equivalent of glycidyl methacrylate to undergo addition reaction with the carboxyl group of a copolymer obtained from 25 mass% of methyl methacrylate, 25 mass% of styrene, and 50 mass% of methacrylic acid. The resin 1 obtained had a weight-average molecular weight of 34,000, an acid value of 105 mgKOH/g, and an iodine value of 2.0 mol/kg.

Resin 2: this resin was composed of a copolymer having neither an ethylenically unsaturated group nor a hydrophilic group, and was obtained from 25 mass% of methyl methacrylate, 25 mass% of styrene, and 50 mass% of methacrylic acid. The weight-average molecular weight was 30,000.

(Polymerizable monomer)

Polymerizable monomer 1: "Miramer" (registered trademark) M340 (manufactured by Miwon Specialty Chemical Co., Ltd.), a mixture of pentaerythritol triacrylate and pentaerythritol tetraacrylate. This monomer had a hydroxyl group and a hydroxyl value of 115 mgKOH/g.

Polymerizable monomer 2: tricyclodecane dimethanol diacrylate "Miramer" (registered trademark) M262 (manufactured by Miwon Specialty Chemical Co., Ltd.). This monomer had no hydroxyl group and a hydroxyl value of 0 mgKOH/g.

Polymerizable monomer 3: 1,6-hexanediol diacrylate (LIGHT ACRYLATE 1.6HX-A, manufactured by Kyoeisha Chemical Co., Ltd.). This monomer had no hydroxyl group and a hydroxyl value of 0 mgKOH/g.

Polymerizable monomer 4: 1,10-decanediol diacrylate (NK ester A-DOD-N, manufactured by Shin-Nakamura Chemical Co., Ltd.). This monomer had no hydroxyl group and a hydroxyl value of 0 mgKOH/g.

(Other additives)

Polymerization inhibitor: p-methoxyphenol (manufactured by Wako Pure Chemical Industries, Ltd.)

Pigment: SEIKA CYANINE BLUE 4920 (manufactured by Dainichiseika Color & Chemicals Mfg. Co., Ltd.)

Extender pigment: MICRO ACEP-8 (manufactured by Nippon Talc Co., Ltd.)

Wax: polytetrafluoroethylene fine powder "KTL-4N" (registered trademark)

(manufactured by Kitamura Limited)

[Example 1]

An ink composition containing a resin, polymerizable monomer 1, polymerizable monomer 2, polymerization inhibitor, pigment, urethane acrylate 1, extender pigment, and wax as mentioned in Table 1 was weighed, and a three-roll mill "EXAKT" (registered trademark) M-80S (manufactured by Exakt Technologies, Inc.) was used to pass the ink composition through the device three times with the setting of "Gap 1" to obtain a printing ink.

The resulting printing ink was used to produce film laminates before and after hot-water treatment as above-mentioned, and the film laminates were evaluated for adhesion. The peel strength of the laminate was good, 1.8 N/15 mm, before hot-water treatment, and good, 1.9 N/15 mm, also after hot-water treatment.

In addition, the appearance of the coating was good, having no abnormality such as printing unevenness.

[Examples 2 to 6]

The same operation and evaluation of adhesion as in Example 1 were performed except that the ink composition was changed as in Table 1. Increasing the amount of urethane acrylate 1 exhibited a tendency to enhance the peel strength of the laminate before and after hot-water treatment, compared with Example 1. In addition, decreasing the amounts of the resin and the urethane acrylate tended to decrease the tack. In addition, adding a different urethane acrylate 2 afforded good adhesion. In this regard, the density of the solid portion in the evaluation of ink transfer in Example 2 was 1.4.

[Example 7]

The same operation and evaluation of adhesion as in Example 1 were performed except that the ink composition was changed as in Table 1. Example 10 included polymerizable monomer 3 (1,6-hexanediol diacrylate). The peel strength of the laminate was 2.4 N/15 mm before hot-water treatment, and 2.6 N/15 mm after hot-water treatment. A very good adhesive force was thus exhibited. In addition, the density of the solid portion in the evaluation of ink transfer was 1.6.

[Example 8]

The same operation and evaluation of adhesion as in Example 1 were performed except that the ink composition was changed as in Table 1. Example 11 included polymerizable monomer 4 (1,10-decanediol diacrylate). The peel strength of the laminate was 2.7 N/15 mm before hot-water treatment, and 2.7 N/15 mm after hot-water treatment. A very good adhesive force was thus exhibited. In addition, the density of the solid portion in the evaluation of ink transfer was 1.7.

[Examples 9 to 11]

The ink composition was fixed as in Table 1, the film substrates to be used for printing were of polyamide, polypropylene, and polyester respectively, and the same operation and evaluation of adhesion as in Example 1 were performed on each material. In Example 9, a very good adhesion was exhibited, 3.3 N/15 mm before hot-water treatment, and 3.4 N/15 mm after hot-water treatment. In Examples 10 and 11, the adhesive force was higher than 3 N/15 mm, and the failure mode was substrate failure. A particularly good adhesion was thus exhibited.

[Example 12]

The same operation and evaluation of adhesion as in Example 1 were performed except that the ink composition was changed as in Table 2. Also in this Example, a good adhesion was exhibited, 1.8 N/15 mm before hot-water treatment, and 1.7 N/15 mm after hot-water treatment.

[Examples 13 to 16]

The same operation and evaluation of adhesion as in Example 1 were performed except that the ink composition was changed as in Table 2. All the urethane acrylates exhibited a good adhesion.

[Comparative Example 1]

The same operation and evaluation of adhesion as in Example 1 were performed except that the ink composition was changed as in Table 2. The ink containing no urethane acrylate has revealed that the peel strength of the laminate was insufficient, 1.4 N/15 mm before hot-water treatment, and even poorer, 0.9 N/15 mm after hot-water treatment.

[Comparative Example 2]

The same operation and evaluation of adhesion as in Example 1 were performed except that the ink composition was changed as in Table 2. The ink the tack of which was low, 4.0, and the ink viscosity ratio (B)/(C) of which was low, 0.55, has revealed that the coating appearance and the anti-scumming were both poorer. This is considered to be because the tack due to the cohesive force of the ink was not suitably retained, thus degrading the ink transfer, and in addition, impairing the Newtonian property.

[Comparative Example 3]

The same operation and evaluation of adhesion as in Example 1 were performed except that the ink composition was changed as in Table 2. The ink in which the amount of urethane acrylate 1 was large, 35 mass%, has revealed that the peel strength of the laminate was 3.2 N/15 mm before hot-water treatment, and 3.6 N/15 mm after hot-water treatment, exhibiting a very good adhesive force, although the coating appearance was poorer. This is considered to be because the large amount of urethane acrylate made the tack value of the ink markedly high.

The compositions of the components used and the evaluation results in Examples and the Comparative Examples are tabulated in Tables 1 and 2.

[Table 1]

| | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|
| Ink Composition (parts by mass) | Resin 1 | 10.5 | 10.5 | 10.5 | 6.0 | 10.5 | 10.5 | 10.5 | 10.5 | 10.5 | 10.5 | 10.5 |
| | Resin 2 | - | - | - | - | - | - | - | - | - | - | - |
| | Polymerizable Monomer 1 | 32.5 | 29.0 | 26.0 | 34.7 | 34.0 | 29.0 | 29.0 | 29.0 | 32.5 | 32.5 | 32.5 |
| | Polymerizable Monomer 2 | 32.4 | 28.9 | 25.9 | 34.7 | 33.9 | 28.9 | 25.9 | 25.9 | 32.4 | 32.4 | 32.4 |
| | Polymerizable Monomer 3 | - | - | - | - | - | - | 3.0 | - | - | - | - |
| | Polymerizable Monomer 4 | - | - | - | - | - | - | - | 3.0 | - | - | - |
| | Polymerization Inhibitor | 0.1 | 0.1 | 0.1 | 0.1 | 0.1 | 0.1 | 0.1 | 0.1 | 0.1 | 0.1 | 0.1 |
| | Pigment | 18 | 18 | 18 | 18 | 18 | 18 | 18 | 18 | 18 | 18 | 18 |
| | Urethane Acrylate 1 | 5 | 12 | 18 | 5 | 2 | - | 12 | 12 | - | - | - |
| | Urethane Acrylate 2 | - | - | - | - | - | 12 | - | - | - | - | - |
| | Urethane Acrylate 3 | - | - | - | - | - | - | - | - | 5 | 5 | 5 |
| | Urethane Acrylate 4 | - | - | - | - | - | - | - | - | - | - | - |
| | Urethane Acrylate 5 | - | - | - | - | - | - | - | - | - | - | - |
| | Urethane Acrylate 6 | - | - | - | - | - | - | - | - | - | - | - |
| | Urethane Acrylate 7 | - | - | - | - | - | - | - | - | - | - | - |
| | Extender Pigment | 1 | 1 | 1 | 1 | 1 | 1 | 1 | 1 | 1 | 1 | 1 |
| | Wax | 0.5 | 0.5 | 0.5 | 0.5 | 0.5 | 0.5 | 0.5 | 0.5 | 0.5 | 0.5 | 0.5 |
| Substrate | PA, OPP, or PET | PA | PA | PA | PA | PA | PA | PA | PA | PA | OPP | PET |

| | | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|---|
| Evaluation Results | Laminate Peel Strength [N/15 mm] * Substrate Failure | Before Hot-water Treatment | 1.8 | 2.5 | 3.1 | 1.8 | 1.6 | 2.0 | 2.4 | 2.7 | 3.3 | 3.4* | 3.2* |
| | | After Hot-water Treatment | 1.9 | 2.9 | 3.0 | 1.8 | 1.7 | 2.2 | 2.6 | 2.7 | 3.4 | 3.5* | 3.3* |
| | Compatibility | | S | S | S | S | S | A | S | S | ss | ss | ss |
| | Ink Viscosity (C) 20 rpm | | 36.3 | 40.5 | 37.8 | 25.5 | 35.1 | 50.4 | 27.7 | 26.2 | 29.8 | 29.8 | 29.8 |
| | Ink Viscosity (B) 50 rpm | | 30.1 | 32.9 | 29.2 | 17.1 | 24.4 | 38.0 | 22.4 | 21.0 | 27.1 | 27.1 | 27.1 |
| | Ink Viscosity Ratio (B)/(C) | | 0.83 | 0.81 | 0.77 | 0.67 | 0.70 | 0.75 | 0.81 | 0.80 | 0.91 | 0.91 | 0.91 |
| | Printability | Coating Appearance | A | A | B | A | A | B | A | A | A | A | A |
| | | Tack Value | 8.6 | 12.7 | 17.6 | 5.3 | 8.5 | 14.0 | 10.6 | 10.1 | 10.9 | 10.9 | 10.9 |
| | | Anti-scumming | A | A | A | B | A | A | A | A | S | S | S |
| | | Density of Solid Portion | 1.5 | 1.4 | 1.3 | 1.4 | 1.5 | 1.3 | 1.6 | 1.7 | 1.9 | 1.9 | 1.9 |

[Table 2]

| | | Example 12 | Example 13 | Example 14 | Example 15 | Example 16 | Comparative Example 1 | Comparative Example 2 | Comparative Example 3 |
|---|---|---|---|---|---|---|---|---|---|
| Ink Composition (parts by mass) | Resin 1 | - | 10.5 | 10.5 | 10.5 | 10.5 | 11.7 | 4.0 | 10.5 |
| | Resin 2 | 18.0 | - | - | - | - | - | - | - |
| | Polymerizable Monomer 1 | 28.7 | 32.5 | 32.5 | 32.5 | 32.5 | 42.1 | 35.7 | 17.5 |
| | Polymerizable Monomer 2 | 28.7 | 32.4 | 32.4 | 32.4 | 32.4 | 24.1 | 35.7 | 17.4 |
| | Polymerizable Monomer 3 | - | - | - | - | - | - | - | - |
| | Polymerizable Monomer 4 | - | - | - | - | - | - | - | - |
| | Polymerization Inhibitor | 0.1 | 0.1 | 0.1 | 0.1 | 0.1 | 0.1 | 0.1 | 0.1 |
| | Pigment | 18 | 18 | 18 | 18 | 18 | 18 | 18 | 18 |
| | Urethane Acrylate 1 | 5 | - | - | - | - | - | 5 | 35 |
| | Urethane Acrylate 2 | - | - | - | - | - | - | - | - |
| | Urethane Acrylate 3 | - | - | - | - | - | - | - | - |
| | Urethane Acrylate 4 | - | 5 | - | - | - | - | - | - |
| | Urethane Acrylate 5 | - | - | 5 | - | - | - | - | - |
| | Urethane Acrylate 6 | - | - | - | 5 | - | - | - | - |
| | Urethane Acrylate 7 | - | - | - | - | 5 | - | - | - |
| | Extender Pigment | 1 | 1 | 1 | 1 | 1 | 3 | 1 | 1 |
| | Wax | 0.5 | 0.5 | 0.5 | 0.5 | 0.5 | 1 | 0.5 | 0.5 |
| Substrate | PA, OPP, or PET | PA | PA | PA | PA | PA | PA | PA | PA |

| | | | Example 12 | Example 13 | Example 14 | Example 15 | Example 16 | Comparative Example 1 | Comparative Example 2 | Comparative Example 3 |
|---|---|---|---|---|---|---|---|---|---|---|
| Evaluation Results | Laminate Peel Strength [N/15 mm] * Substrate Failure | Before Hot-water Treatment | 1.8 | 3.6 | 3.1 | 3.3 | 3.0 | 1.4 | 1.6 | 3.2 |
| | | After Hot-water Treatment | 1.7 | 3.8 | 3.3 | 4.0 | 3.2 | 0.9 | 1.4 | 3.6 |
| | Compatibility | | A | B | s | ss | A | - | A | s |
| | Ink Viscosity (C) 20 rpm | | 25.0 | 35.5 | 29.3 | 29.9 | 35.8 | 32.0 | 18.5 | 72.1 |
| | Ink Viscosity (B) 50 rpm | | 21.2 | 22.0 | 25.9 | 26.2 | 24.5 | 22.6 | 10.1 | 35.6 |
| | Ink Viscosity Ratio (B)/(C) | | 0.85 | 0.62 | 0.88 | 0.88 | 0.68 | 0.71 | 0.55 | 0.49 |
| | Printability | Coating Appearance | A | A | A | A | A | A | C | C |
| | | Tack Value | 10.5 | 9.6 | 9.2 | 8.9 | 9.8 | 8.5 | 4.0 | 23.1 |
| | | Anti-scumming | A | B | A | S | A | A | C | B |
| | | Density of Solid Portion | 1.4 | 1.3 | 1.7 | 1.9 | 1.5 | 1.2 | 1.2 | 1.1 |

EP 3 974 201 A1

23

[Examples 17 to 22]

A waterless lithography plate was produced, wherein a silicone rubber layer was formed in the below-mentioned amount before development. The waterless lithography plate underwent development and then evaluated for the image reproducibility of halftone dots by visual observation using a loupe at a magnification ratio of 50×.

Example 17: 2.6 g/m$^2$
Example 18: 3.0 g/m$^2$
Example 19: 4.5 g/m$^2$
Example 20: 6.0 g/m$^2$
Example 21: 8.0 g/m$^2$
Example 22: 9.0 g/m$^2$

Examples 20 and 21 resulted in good image reproducibility, and Examples 17 to 19 resulted in better image reproducibility. In Example 22, dots were found to be broken during the development of the lithography plate, but at a practically unproblematic level.

In addition, evaluating the printing resistance using the printing ink and substrate of Example 9 made it possible to verify the good printing resistance in Example 17 and the better printing resistance in Examples 18 to 22.

## Claims

1. A printing ink, comprising (a) a urethane (meth)acrylate and (c) another polymerizable monomer,

   wherein the printing ink has an ink tack value of 5.0 or more and 18.0 or less and a viscosity (C) and a viscosity (B) that are both 5 Pa·s or more and 100 Pa·s or less, as measured at a rotational speed of 20 rpm and a rotational speed of 50 rpm respectively at 35°C, using a cone-plate rotating viscometer, and
   wherein the viscosity ratio (B)/(C) is 0.60 or more and 1.00 or less.

2. The printing ink according to claim 1, further comprising a resin.

3. The printing ink according to claim 1 or 2, comprising said (a) urethane (meth)acrylate in an amount of 1 to 30 mass% with respect to 100 mass% of the ink.

4. The printing ink according to any one of claims 1 to 3, wherein said (a) urethane (meth)acrylate has a weight-average molecular weight (Mw) of 500 to 10,000.

5. The printing ink according to any one of claims 1 to 4, wherein said (a) urethane (meth)acrylate has a urethane bond fraction of 5 mass% or more and 40 mass% or less.

6. The printing ink according to any one of claims 1 to 5, wherein said (a) urethane (meth)acrylate has at least an ether structure in the polyol thereof.

7. The printing ink according to any one of claims 2 to 6, wherein said resin is (b) a resin having an ethylenically unsaturated group and a hydrophilic group.

8. A printing ink, comprising: (a) a urethane (meth)acrylate; (b) a resin having an ethylenically unsaturated group and a hydrophilic group; and (c) another polymerizable monomer.

9. The printing ink according to any one of claims 1 to 8, wherein said (c) another polymerizable monomer contains at least a hydroxyl-group-containing polyfunctional (meth)acrylate.

10. The printing ink according to any one of claims 1 to 9, wherein the ratio of said (a) urethane (meth)acrylate is 3 mass% or more and 40 mass% or less with respect to said (c) another polymerizable monomer.

11. A printing ink according to any one of claims 1 to 10, which is used for an active energy ray-curable lithography plate.

12. A method of producing a printed material by lithography using the printing ink according to any one of claims 1 to 11, the method comprising a step of transferring the ink to a substrate to be printed, followed by irradiating the resulting material with an active energy ray.

13. The method of producing a printed material according to claim 12, wherein said substrate comprises at least one selected from the group consisting of polypropylenes, polyethylenes, polyesters, and polyamides.

14. The method of producing a printed material according to claim 12 or 13, wherein the printing side surface of said substrate comprises a plastic film having an easily adhesive layer containing an organic material.

15. The method of producing a printed material according to claim 14, wherein said easily adhesive layer has at least a urethane structure.

16. The method for producing a printed material according to any one of claims 12 to 15, wherein said active energy ray is an electron beam or LED-UV.

17. The method of producing a printed material according to claim 16, wherein the irradiation amount of said electron beam is 5 kGy or more and 80 kGy or less.

18. A method of producing a printed material by lithography using the printing ink according to any one of claims 1 to 11, the method comprising using a waterless lithography plate as a lithography plate.

19. The method of producing a printed material according to claim 18, wherein a silicone layer of said waterless lithography plate is formed in an amount of 3.0 to 8.0 $g/m^2$ before development.

20. A method of producing a printed material, comprising the steps of: printing a substrate by lithography using said printing ink according to any one of claims 1 to 11, followed by irradiating the resulting material with an active energy ray; laminating at least a sealant film onto the printed substrate; and performing a hot-water treatment.

21. A printed material comprising at least a substrate, said printing ink according to any one of claims 1 to 11, an adhesive, and a sealant film.

22. A printed material according to claim 21, wherein an adhesive strength between said substrate and said printing ink is 1.5 N/15 mm or more, or results in substrate failure.

## INTERNATIONAL SEARCH REPORT

| International application No. |
|---|
| PCT/JP2020/019778 |

### A. CLASSIFICATION OF SUBJECT MATTER

B41M 1/30(2006.01)i; C09D 11/101(2014.01)i
FI: C09D11/101; B41M1/30 D; B41M1/30 B
According to International Patent Classification (IPC) or to both national classification and IPC

### B. FIELDS SEARCHED

Minimum documentation searched (classification system followed by classification symbols)
B41M1/30; C09D11/101

| Documentation searched other than minimum documentation to the extent that such documents are included in the fields searched | |
|---|---|
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2006/003811 A1 (MATSUI CHEMICAL CO., LTD.) 12.01.2006 (2006-01-12) claims, paragraphs [0024], [0031]-[0032], [0046]-[0049], [0056], [0058], [0069], [0071], [0080]-[0087], [0089], examples | 1-8, 10-17, 20-22 |
| A | claims, paragraphs [0024], [0031]-[0032], [0046]-[0049], [0056], [0058], [0069], [0071], [0080]-[0087], [0089], examples | 9, 18-19 |
| X | JP 10-030012 A (DAINIPPON INK AND CHEMICALS, INCORPORATED) 03.02.1998 (1998-02-03) claims, paragraphs [0033], [0036]-[0037], [0039], examples | 8-9, 21-22 |
| A | claims, paragraphs [0033], [0036]-[0037], [0039], examples | 1-7, 10-20 |
| A | JP 07-292304 A (TOYOBO BOSEKI KABUSHIKI KAISHA) 07.11.1995 (1995-11-07) claims, examples | 1-22 |
| A | JP 06-172695 A (TOYO INK MANUFACTURING CO., LTD.) 21.06.1994 (1994-06-21) claims, examples | 1-22 |

☒ Further documents are listed in the continuation of Box C.     ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 03 August 2020 (03.08.2020) | 11 August 2020 (11.08.2020) |

| Name and mailing address of the ISA/ | Authorized officer |
|---|---|
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**

International application No.

PCT/JP2020/019778

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2001-348516 A (DAINIPPON INK AND CHEMICALS, INCORPORATED) 18.12.2001 (2001-12-18) claims, examples | 1-22 |
| A | JP 2003-327887 A (TANIGUCHI INK SEIZO KK) 19.11.2003 (2003-11-19) claims, examples | 1-22 |

Form PCT/ISA/210 (continuation of second sheet) (January 2015)

INTERNATIONAL SEARCH REPORT
Information on patent family members

International application no.

PCT/JP2020/019778

| Patent Documents referred in the Report | Publication Date | Patent Family | Publication Date |
|---|---|---|---|
| WO 2006/003811 A1 | 12 Jan. 2006 | US 2008/0108760 A1 claims, paragraphs [0025], [0032]-[0033], [0047]-[0049], [0057], [0059], [0070], [0072], [0081]-[0088], [0090], examples EP 1762600 A1 CA 2572013 A KR 10-2007-0038107 A CN 101001928 A TW 200615344 A | |
| JP 10-030012 A | 03 Feb. 1998 | (Family: none) | |
| JP 07-292304 A | 07 Nov. 1995 | (Family: none) | |
| JP 06-172695 A | 21 Jun. 1994 | (Family: none) | |
| JP 2001-348516 A | 18 Dec. 2001 | (Family: none) | |
| JP 2003-327887 A | 19 Nov. 2003 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H03252472 A
- WO 2015141552 A